# EUROPEAN PATENT APPLICATION

(11) **EP 4 801 243 A1**
(43) Date of publication of application: **02.09.2026**
(21) Application number: 25220140.5
(22) Date of filing: 02.12.2025
(51) Int. Cl.: H10K 59/122

(54) **DISPLAY DEVICE, ELECTRONIC DEVICE AND METHOD FOR FABRICATING DISPLAY DEVICE**

(30) Priority: 26.02.2025 KR 20250024765
(71) Applicant: Samsung Display Co., Ltd., Yongin-si, Gyeonggi-do 17113 (KR)
(72) Inventor: YOU, Chun Gi, Yongin-si (KR)
(74) Representative: Marks & Clerk LLP

(57) **Abstract**

The present disclosure relates to a display device, an electronic device, and a method for fabricating the display device. The display device comprises a first electrode in a sub-pixel area; a power connection electrode in a power connection area; an intermediate layer on the first electrode and the power connection electrode; a bank layer on the intermediate layer; a light emitting stack layer on the first electrode and the bank layer; and a second electrode on the light emitting stack layer and connected to the power connection electrode. The bank layer comprises a first bank and a second bank. An edge of the second bank extends beyond an edge of the first bank in the sub-pixel area, and an edge of the first bank extends beyond an edge of the second bank in the power connection area.

## Description

### BACKGROUND

### 1. Technical Field

The present disclosure relates to a display device, and more particularly, to a display device, an electronic device, and/or a method for fabricating the display device.

### 2. Description of the Related Art

An organic light emitting display device includes a display element of which luminance is changed by current, for example, an organic light emitting diode (OLED).

A head mounted display (HMD) to which an organic light emitting display device is applied is an image display device that is worn on a user's head in the form of glasses or helmets to form a focus at a close distance in front of the user's eyes. The head mounted display may implement in virtual reality (VR) or augmented reality (AR).

The head mounted display magnifies an image displayed on a small display device by using a plurality of lenses, and displays the magnified image. Therefore, the display device applied to the head mounted display may be configured to provide high-resolution images, for example, images with a resolution of 3000 PPI (Pixels Per Inch) or higher. To this end, an organic light emitting diode on silicon (OLEDoS), which is a high-resolution small organic light emitting display device, may be used as the display device applied to the head mounted display. The OLEDoS is an image display device in which an organic light emitting diode (OLED) is located on a semiconductor wafer substrate on which a complementary metal oxide semiconductor (CMOS) is located.

### SUMMARY

Aspects of the present disclosure provide a display device, an electronic device, and/or a method for fabricating the display device.

According to at least one example embodiment of the present disclosure, there is provided a display device comprising: a substrate comprising a display area and a non-display area; a first electrode in a sub-pixel area of the display area; a power connection electrode in a power connection area of the non-display area; a capping layer on the first electrode and the power connection electrode, the capping layer having a first opening overlapping the first electrode and a second opening overlapping the power connection electrode; a planarization layer on the capping layer, the planarization layer defining a third opening overlapping the first opening and a fourth opening overlapping the second opening; a protective layer on the planarization layer, the protective layer defining a fifth opening overlapping the third opening and a sixth opening overlapping the fourth opening; a bank layer on the protective layer; a light emitting stack layer on the first electrode and the bank layer; and a second electrode on the light emitting stack layer and connected to the power connection electrode through the second opening, the fourth opening, and the sixth opening, wherein the bank layer comprises a first bank on the protective layer and a second bank on the first bank, an edge of the second bank, in the sub-pixel area, extends beyond an edge of the first bank toward the fifth opening of the protective layer, and an edge of the first bank, in the power connection area, extends beyond an edge of the second bank toward the sixth opening of the protective layer.

According to at least one example embodiment of the present disclosure, there is provided a display device comprising: a substrate comprising a display area and a non-display area; a first electrode in a sub-pixel area of the display area; a power connection electrode in a power connection area of the non-display area; an intermediate layer on the first electrode and on the power connection electrode, the intermediate layer defining a first opening portion and a second opening portion, the first opening portion overlapping the first electrode and the second opening portion overlapping the power connection electrode; a bank layer on the intermediate layer, the bank layer defining a third opening portion overlapping the first opening portion and a fourth opening portion overlapping the second opening portion; a light emitting stack layer on the first electrode and the bank layer; and a second electrode on the light emitting stack layer and electrically connected to the power connection electrode through the second opening portion and the fourth opening portion, wherein the bank layer has an undercut structure in the sub-pixel area, and the bank layer has a non-undercut structure in the power connection area.

According to at least one example embodiment of the present disclosure, there is provided an electronic device comprising: a display device having a resolution of 4,000 pixels per inch (PPI) or more; an optical member outside the display device, the optical member configured to adjust a path of light emitted from the display device; and wherein the display device comprises a substrate comprising a display area and a non-display area; a first electrode in a sub-pixel area of the display area; a power connection electrode in a power connection area of the non-display area; a capping layer on the first electrode and the power connection electrode, the capping layer having a first opening overlapping the first electrode and a second opening overlapping the power connection electrode; a planarization layer on the capping layer, the planarization layer defining a third opening overlapping the first opening and a fourth opening overlapping the second opening; a protective layer on the planarization layer, the protective layer defining a fifth opening overlapping the third opening and a sixth opening overlapping the fourth opening; a bank layer on the protective layer; a light emitting stack layer on the first electrode and the bank layer; and a second electrode on the light emitting stack layer and connected to the power connection electrode through the second opening, the fourth opening, and the sixth opening, wherein the bank layer comprises a first bank on the protective layer and a second bank on the first bank, an edge of the second bank, in the sub-pixel area, extends beyond an edge of the first bank toward the fifth opening of the protective layer, and an edge of the first bank, in the power connection area, extends beyond an edge of the second bank toward the sixth opening of the protective layer.

According to at least one example embodiment of the present disclosure, there is provided an electronic device comprising: a display device having a resolution of 4,000 pixels per inch (PPI) or more; an optical member outside the display device, the optical member configured to adjust a path of light emitted from the display device; and wherein the display device comprises a substrate comprising a display area and a non-display area, a first electrode located in a sub-pixel area of the display area, a power connection electrode in a power connection area of the non-display area, an intermediate layer on the first electrode and the power connection electrode, the intermediate layer defining a first opening portion and a second opening portion, the first opening portion overlapping the first electrode and the second opening portion overlapping the power connection electrode, a bank layer on the intermediate layer, the bank layer defining a third opening portion and a fourth opening portion, the third opening portion overlapping the first opening portion and the fourth opening portion overlapping the second opening portion, a light emitting stack layer on the first electrode and the bank layer, and a second electrode on the light emitting stack layer and connected to the power connection electrode through the second opening portion and the fourth opening portion, and wherein the bank layer has an undercut structure in the sub-pixel area, and the bank layer has a non-undercut structure in the power connection area.

According to at least one example embodiment of the present disclosure, there is provided a method for fabricating a display device, comprising: preparing a substrate comprising a display area and a non-display area; forming a first electrode in a sub-pixel area of the display area; forming a power connection electrode in a power connection area of the non-display area; forming a preliminary capping layer on the first electrode and the power connection electrode; forming a preliminary planarization layer on the preliminary capping layer; forming a preliminary protective layer on the preliminary planarization layer; forming a first bank layer on the preliminary protective layer; forming a second bank layer on the first bank layer such that the second bank layer has an etching rate lower than that of the first bank layer; forming a first photoresist pattern on the second bank layer; patterning the first bank layer and the second bank layer by a physical etching method using the first photoresist pattern as a mask to form a first preliminary bank and a second preliminary bank; patterning the first preliminary bank and the second preliminary bank by a chemical etching method using the first photoresist pattern as a mask to form a third preliminary bank on the preliminary protective layer and form a fourth preliminary bank having a larger width than the third preliminary bank on the third preliminary bank; forming a second photoresist pattern on the fourth preliminary bank of the display area, the preliminary protective layer of the display area and the fourth preliminary bank of the non-display area so as to cover the entire second preliminary bank of the display area and the entire third preliminary bank of the display area, and so as not to overlap an edge of the third preliminary bank of the non-display area and an edge of the fourth preliminary bank of the non-display area; and patterning the preliminary capping layer, the preliminary planarization layer, the preliminary protective layer, the third preliminary bank and the fourth preliminary bank by a physical etching method using the second photoresist pattern as a mask to form a capping layer, a planarization layer, a protective layer, a first bank and a second bank having a first opening exposing a first electrode of the sub-pixel area and a second opening exposing a power connection electrode of the power connection area, wherein in the sub-pixel area, an edge of the second bank extends beyond an edge of the first bank toward the first opening of the protective layer, and in the power connection area, an edge of the first bank extends beyond an edge of the second bank toward the second opening of the protective layer.

According to at least one example embodiment of the present disclosure, there is provided a method for fabricating a display device, comprising: preparing a substrate comprising a display area and a non-display area; forming a first electrode in a sub-pixel area of the display area; forming a power connection electrode in a power connection area of the non-display area; forming a preliminary capping layer on the first electrode and the power connection electrode; forming a preliminary planarization layer on the preliminary capping layer; forming a preliminary protective layer on the preliminary planarization layer; forming a first bank layer on the preliminary protective layer; forming a first photoresist pattern on the first bank layer to cover the first bank layer of the display area; patterning the first bank layer by a physical etching method using the first photoresist pattern as a mask to form a first preliminary bank in the display area and expose the preliminary protective layer of the non-display area; forming a second bank layer having an etching rate lower than that of the first bank on the first preliminary bank of the display area and the preliminary protective layer of the non-display area; forming a second photoresist pattern on the second bank layer of the display area and the preliminary protective layer of the non-display area so as to expose the second bank layer of the sub-pixel area and cover the preliminary protective layer of the non-display area; patterning the first preliminary bank and the second bank layer by a physical etching method using the second photoresist pattern as a mask to form a second preliminary bank and a third preliminary bank; patterning the second preliminary bank and the third preliminary bank by a chemical etching method using the second photoresist pattern as a mask to form a fourth preliminary bank on the preliminary protective layer of the display area, and form a fifth preliminary bank having a larger width than the fourth preliminary bank on the fourth preliminary bank; forming a third photoresist pattern on the fifth preliminary bank of the display area, the preliminary protective layer of the display area and the fifth preliminary bank of the non-display area so as to cover the entire fourth preliminary bank of the display area and the entire fifth preliminary bank of the display area and so as not to overlap the power connection electrode of the non-display area; and patterning the preliminary capping layer, the preliminary planarization layer, the preliminary protective layer, the fourth preliminary bank and the fifth preliminary bank by a physical etching method using the third photoresist pattern as a mask to form a capping layer, a planarization layer, a protective layer, a first bank and a second bank having a first opening exposing the first electrode of the sub-pixel area and a second opening exposing the power connection electrode of the power connection area, wherein in the sub-pixel area, an edge of the second bank extends beyond an edge of the first bank toward the first opening of the protective layer, and in the power connection area, an edge of the protective layer extends beyond an edge of the second bank toward the second opening of the protective layer.

At least some of the above and other features of the invention are set out in the claims.

According to at least one example embodiment, damage to an electrode may be protected against in a power connection area.

For example, according to at least one example embodiment, since the width of a second bank is smaller than the width of a first bank in a non-display area, the electrode (e.g., a second electrode) located on the first bank and the second bank of the non-display area may be protected against being disconnected.

In addition, according to at least one example embodiment, since the width of the second bank is smaller than the width of a protective layer in the non-display area, the electrode (e.g., the second electrode) located on the second bank and the protective layer of the non-display area may be protected against being disconnected.

Accordingly, the second electrode may be normally connected to a power connection electrode in the power connection area.

The effects of the present disclosure are not limited to the above-described effects and other effects which are not described herein will become apparent to those skilled in the art from the following description.

### BRIEF DESCRIPTION OF THE DRAWINGS

The above and other aspects and features of the present disclosure will become more apparent by describing in detail example embodiments thereof with reference to the attached drawings, in which:
FIG. 1 is an exploded perspective view showing a display device according to at least one example embodiment;
FIG. 2 is a block diagram illustrating a display device according to at least one example embodiment;
FIG. 3 is a layout diagram illustrating an example of a display panel according to at least one example embodiment;
FIG. 4 is a layout diagram showing at least one example embodiment of the display area of FIG. 3;
FIG. 5 is a cross-sectional view showing an example of a display panel taken along line I1-I1' of FIG. 4;
FIG. 6 is a cross-sectional view showing area A1 of FIG. 5 in detail;
FIG. 7 is a cross-sectional view showing area A2 of FIG. 6 in detail;
FIG. 8 is a cross-sectional view illustrating an example of the display panel taken along line I1-I1' of FIG. 3;
FIGS. 9, 10, 11, 12, 13, 14, 15, 16, 17, 18, 19, and 20 are process cross-sectional views for explaining a method for fabricating the display device according to at least one example embodiment;
FIG. 21 is a cross-sectional view illustrating another example of the display panel 100 taken along line I1-I1' of FIG. 3;
FIGS. 22, 23, 24, 25, 26, 27, 28, 29, 30, 31, 32, and 33 are process cross-sectional views for explaining a method for fabricating the display device according to at least one example embodiment;
FIG. 34 is a block diagram of an electronic device according to at least one example embodiment;
FIGS. 35, 36 and 37 are schematic diagrams illustrating electronic devices according to various embodiments; and
FIG. 38 is a perspective view illustrating a head mounted display according to at least one example embodiment.

### DETAILED DESCRIPTION OF THE EMBODIMENTS

The present invention will now be described more fully hereinafter with reference to the accompanying drawings, in which preferred embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art.

It will also be understood that when a layer is referred to as being "on" another layer or substrate, it can be directly on the other layer or substrate, or intervening layers may also be present. The same reference numbers indicate the same components throughout the specification. In the attached figures, the thickness of layers and regions is exaggerated for clarity. Additionally, it will also be understood that spatially relative terms, such as "left", "right", "above", etc., are intended to encompass different orientations of the device in use or operation in addition to the orientation depicted in the figures, and that the device may be otherwise oriented (rotated 90 degrees or at other orientations) and the spatially relative terms used herein interpreted accordingly; and the term "upper portion" or "on" may also include "to be present above, below, in the left and right sides on a non-contact basis" as well as "to be on the top, bottom, left, and right portions in directly contact with".

When terms such as "approximately", "substantially", and/or the like are used in relation to numerical values, the relevant numerical value may be construed as including a manufacturing or operation deviation (e.g., ±10 %) of the stated numerical value. Moreover, regardless of whether a numerical value of a shape is limited by using "approximately" or "substantially", such numerical value or shape should be understood as including a manufacturing or operation deviation (e.g., ±10 %) of the stated numerical value.

Although the terms "first", "second", etc. may be used herein to describe various elements, these elements, should not be limited by these terms. These terms may be used to distinguish one element from another element. Thus, a first element discussed below may be termed a second element without departing from teachings of one or more embodiments. The description of an element as a "first" element may not require or imply the presence of a second element or other elements. The terms "first", "second", etc. may also be used herein to differentiate different categories or sets of elements. For conciseness, the terms "first", "second", etc. may represent "first-category (or first-set)", "second-category (or second-set)", etc., respectively.

Features of various embodiments of the present disclosure may be combined partially or totally. As will be clearly appreciated by those skilled in the art, technically various interactions and operations are possible. Various embodiments can be practiced individually or in combination.

Hereinafter, specific example embodiments will be described with reference to the accompanying drawings.

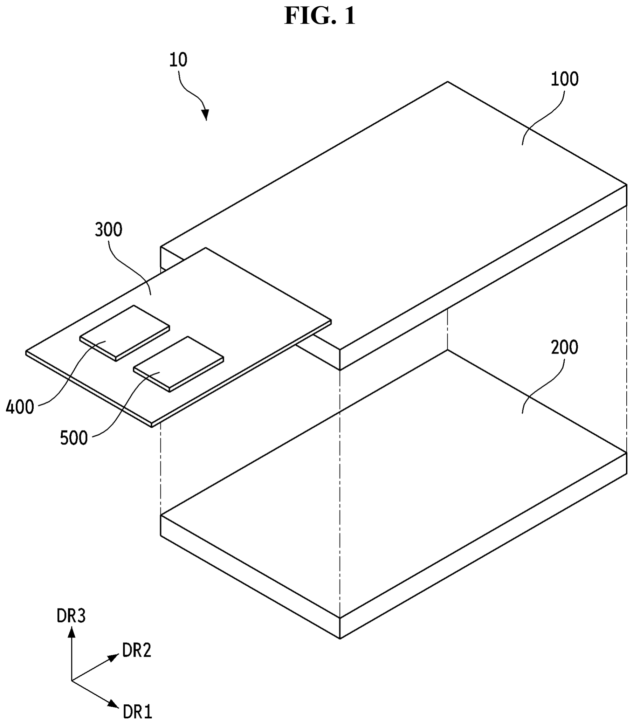

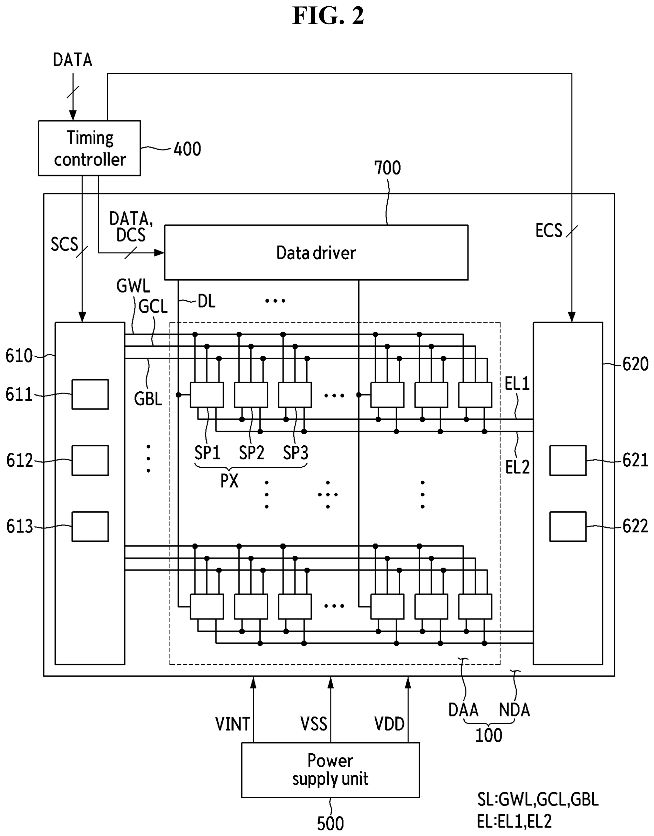

FIG. 1 is an exploded perspective view showing a display device according to at least one example embodiment. FIG. 2 is a block diagram illustrating a display device according to at least one example embodiment.

Referring to FIGS. 1 and 2, a display device 10 according to at least one example embodiment is a device displaying a moving image or a still image. The display device 10 according to at least one example embodiment may be applied to portable electronic devices such as a mobile phone, a smartphone, a tablet personal computer, a mobile communication terminal, an electronic organizer, an electronic book, a portable multimedia player (PMP), a navigation system, an ultra-mobile PC (UMPC), and/or the like. For example, the display device 10 according to at least one example embodiment may be applied as a display unit of a television, a laptop, a monitor, a billboard, and/or an Internet-of-Things (IoT) terminal. Alternatively, the display device 10 according to at least one example embodiment may be applied to a smart watch, a watch phone, a head mounted display (HMD) (e.g., for implementing virtual reality, augmented reality, etc.), and./or the like.

A display device according to at least one example embodiment may have a resolution of, e.g., 4,000 PPI or higher.

The display device 10 according to at least one example embodiment includes a display panel 100, a heat dissipation layer 200, a circuit board 300, a timing control circuit 400, and a power supply circuit 500.

The display panel 100 may have a planar shape similar to a quadrilateral shape. For example, the display panel 100 may have a planar shape having four sides including having a short side of a first direction DR1 and a long side of a second direction DR2 intersecting the first direction DR1. In at least some example embodiments, the display panel 100 may have rounded corners and/or rounded sides, and/or the sides and/or corners may have an indent and/or protrusion. For example, in the display panel 100, a corner where a short side in the first direction DR1 and a long side in the second direction DR2 meet may be right-angled or rounded with a selected curvature. The planar shape of the display panel 100 is not limited to a quadrilateral shape, and may be a shape similar to another polygonal shape, a circular shape, or an elliptical shape. The planar shape of the display device 10 may conform to the planar shape of the display panel 100, but the example embodiments of the present disclosure are not limited thereto.

The display panel 100 includes a plurality of pixels PX, a plurality of scan lines SL, a plurality of emission control lines EL, a plurality of data lines DL, a scan driver 610, an emission driver 620, and a data driver 700. The display panel 100 may be divided into a display area DAA displaying an image and a non-display area NDA not displaying an image as shown in FIG. 2.

The plurality of pixels PX may be arranged in the display area DAA. The plurality of pixels PX may be arranged in a matrix form in the first direction DR1 and the second direction DR2. The plurality of scan lines SL and the plurality of emission control lines EL may extend in the first direction DR1, while being arranged in the second direction DR2. The plurality of data lines DL may extend in the second direction DR2, while being arranged in the first direction DR1.

The plurality of scan lines SL include a plurality of write scan lines GWL, a plurality of control scan lines GCL, and a plurality of bias scan lines GBL. The plurality of emission control lines EL include a plurality of first emission control lines EL1 and a plurality of second emission control lines EL2.

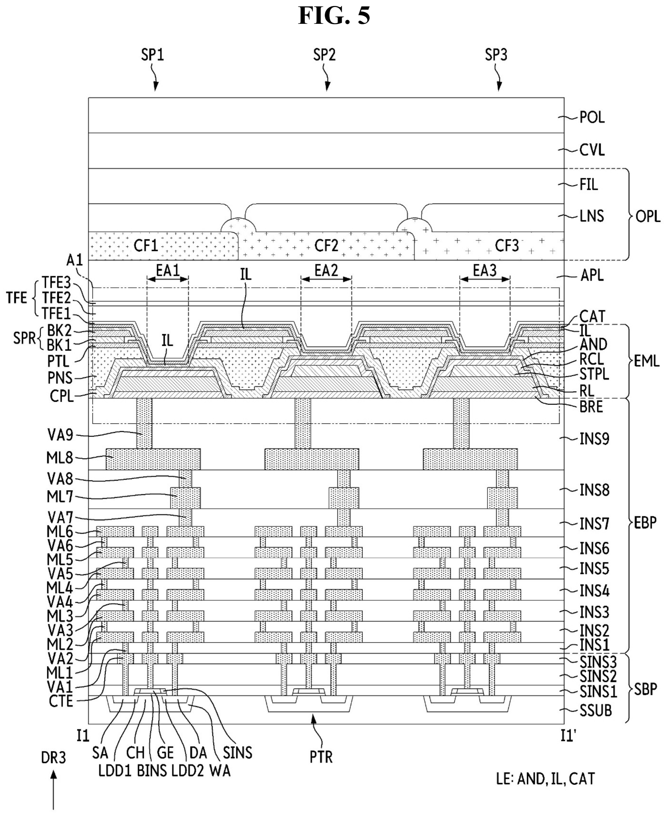

The plurality of pixels PX include a plurality of sub-pixel areas SP1, SP2, and SP3. The plurality of sub-pixel areas SP1, SP2, and SP3 may include a plurality of pixel transistors, and the plurality of pixel transistors may be formed by a semiconductor process and arranged on a semiconductor substrate (e.g., SSUB in FIG. 5). For example, the plurality of pixel transistors may be formed as complementary metal oxide semiconductor (CMOS) transistors, but the example embodiments of the present disclosure are not limited thereto.

Each of the plurality of sub-pixel areas SP1, SP2, and SP3 may be connected to any one write scan line GWL among the plurality of write scan lines GWL, any one control scan line GCL among the plurality of control scan lines GCL, any one bias scan line GBL among the plurality of bias scan lines GBL, any one first emission control line EL1 among the plurality of first emission control lines EL1, any one second emission control line EL2 among the plurality of second emission control lines EL2, and any one data line DL among the plurality of data lines DL. Each of the plurality of sub-pixel areas SP1, SP2, and SP3 may receive a data voltage of the data line DL in response to a write scan signal of the write scan line GWL, and emit light from the light emitting element according to the data voltage.

The scan driver 610, the emission driver 620, and the data driver 700 may be located in the non-display area NDA.

The scan driver 610 includes a plurality of scan transistors, and the emission driver 620 includes a plurality of light emitting transistors. The plurality of scan transistors and the plurality of light emitting transistors may be formed on the semiconductor substrate SSUB (see FIG. 5) through a semiconductor process. For example, the plurality of scan transistors and the plurality of light emitting transistors may be formed as CMOS transistors, but the example embodiments of the present disclosure are not limited thereto.

The scan driver 610 may include a write scan signal output unit 611, a control scan signal output unit 612, and a bias scan signal output unit 613. Each of the write scan signal output unit 611, the control scan signal output unit 612, and the bias scan signal output unit 613 may receive a scan timing control signal SCS from the timing control circuit 400. The write scan signal output unit 611 may generate write scan signals according to the scan timing control signal SCS of the timing control circuit 400 and output them sequentially to the write scan lines GWL. The control scan signal output unit 612 may generate control scan signals in response to the scan timing control signal SCS and sequentially output them to the control scan lines GCL. The bias scan signal output unit 613 may generate bias scan signals according to the scan timing control signal SCS and output them sequentially to the bias scan lines GBL.

The emission driver 620 includes a first emission control driver 621 and a second emission control driver 622. Each of the first emission control driver 621 and the second emission control driver 622 may receive an emission timing control signal ECS from the timing control circuit 400. The first emission control driver 621 may generate first emission control signals according to the emission timing control signal ECS and sequentially output them to the first emission control lines EL1. The second emission control driver 622 may generate second emission control signals according to the emission timing control signal ECS and sequentially output them to the second emission control lines EL2.

The data driver 700 may include a plurality of data transistors, and the plurality of data transistors may be formed on the semiconductor substrate SSUB (see FIG. 5) through a semiconductor process. For example, the plurality of data transistors may be formed as Complementary-Metal-Oxide-Semiconductor (CMOS) transistors, but the example embodiments of the present disclosure are not limited thereto.

The data driver 700 may receive digital video data DATA and a data timing control signal DCS from the timing control circuit 400. The data driver 700 converts the digital video data DATA into analog data voltages according to the data timing control signal DCS and outputs the analog data voltages to data lines DL. In these cases, the sub-pixel areas SP1, SP2, and SP3 may be selected by the write scan signal of the scan driver 610, and data voltages may be supplied to the selected sub-pixel areas SP1, SP2, and SP3.

The heat dissipation layer 200 may overlap the display panel 100 in a third direction DR3, which is a thickness direction of the display panel 100. The heat dissipation layer 200 may be located on one surface, e.g., the rear surface, of the display panel 100. The heat dissipation layer 200 serves to dissipate heat generated from the display panel 100. The heat dissipation layer 200 may include a layer having high thermal conductivity, such as graphite, silver (Ag), copper (Cu), aluminium (Al), and/or the like.

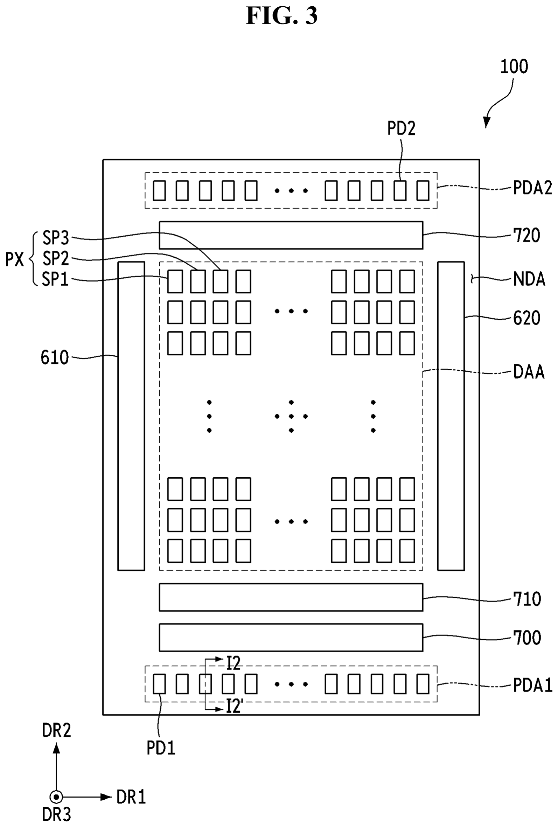

The circuit board 300 may be electrically connected to a plurality of first pads PD1 (see FIG. 3) of a first pad area PDA1 (see FIG. 3) of the display panel 100 by using a conductive adhesive member such as an anisotropic conductive film. In at least one example embodiment, the circuit board 300 may be a flexible printed circuit board with a flexible material, or a flexible film. Although the circuit board 300 is illustrated in FIG. 1 as being unfolded, the circuit board 300 may be bent. In these cases, one end of the circuit board 300 may be located on the rear surface of the display panel 100 and/or the rear surface of the heat dissipation layer 200. The other end of the circuit board 300 may be connected to the plurality of first pads PD1 (see FIG. 3) of the first pad area PDA1 (see FIG. 3) of the display panel 100 by using a conductive adhesive member. One end of the circuit board 300 may be an opposite end of the other end of the circuit board 300.

The timing control circuit 400 may receive digital video data and timing signals inputted from the outside. The timing control circuit 400 may generate the scan timing control signal SCS, the emission timing control signal ECS, and the data timing control signal DCS for controlling the display panel 100 in response to the timing signals. The timing control circuit 400 may output the scan timing control signal SCS to the scan driver 610, and output the emission timing control signal ECS to the emission driver 620. The timing control circuit 400 may output the digital video data and the data timing control signal DCS to the data driver 700.

The power supply circuit 500 may generate a plurality of panel driving voltages according to a power voltage from the outside. For example, the power supply circuit 500 may generate a first driving voltage VSS, a second driving voltage VDD, and a third driving voltage VINT and supply them to the display panel 100.

Each of the timing control circuit 400 and the power supply circuit 500 may be formed as an integrated circuit (IC) and attached to one surface of the circuit board 300. In these cases, the scan timing control signal SCS, the emission timing control signal ECS, the digital video data DATA, and the data timing control signal DCS of the timing control circuit 400 may be supplied to the display panel 100 through the circuit board 300. Further, the first driving voltage VSS, the second driving voltage VDD, and the third driving voltage VINT of the power supply circuit 500 may be supplied to the display panel 100 through the circuit board 300.

Alternatively, each of the timing control circuit 400 and the power supply circuit 500 may be located in the non-display area NDA of the display panel 100, similarly to the scan driver 610, the emission driver 620, and the data driver 700. In these cases, the timing control circuit 400 may include a plurality of timing transistors, and each power supply circuit 500 may include a plurality of power transistors. The plurality of timing transistors and the plurality of power transistors may be formed on the semiconductor substrate SSUB (see FIG. 5) through a semiconductor process. For example, the plurality of timing transistors and the plurality of power transistors may be formed as CMOS transistors, but the example embodiments of the present disclosure are not limited thereto. Each of the timing control circuit 400 and the power supply circuit 500 may be located between the data driver 700 and the first pad area PDA1 (see FIG. 3).

FIG. 3 is a layout diagram illustrating an example of a display panel according to at least one example embodiment.

Referring to FIG. 3, the display area DAA of the display panel 100 according to at least one example embodiment includes the plurality of pixels PX arranged in a matrix form. The non-display area NDA of the display panel 100 according to at least one example embodiment includes the scan driver 610, the emission driver 620, the data driver 700, a first distribution circuit 710, a second distribution circuit 720, the first pad portion PDA1, and a second pad portion PDA2.

The scan driver 610 may be located on a first side of the display area DAA, and the emission driver 620 may be located on a second side of the display area DAA. For example, the scan driver 610 may be located on one side of the display area DAA in the first direction DR1, and the emission driver 620 may be located on the other side of the display area DAA in the first direction DR1. That is, the scan driver 610 may be located on the left side of the display area DAA, and the emission driver 620 may be located on the right side of the display area DAA. However, the example embodiments of the present disclosure are not limited thereto, and the scan driver 610 and the emission driver 620 may be located on both the first side and the second side of the display area DAA.

The first pad portion PDA1 may include the plurality of first pads PD1 connected to pads or bumps of the circuit board 300 through a conductive adhesive member. The first pad portion PDA1 may be located on a third side of the display area DAA. For example, the first pad portion PDA1 may be located on one side of the display area DAA in the second direction DR2. The first pad portion PDA1 may be located outside the data driver 700 in the second direction DR2. That is, the first pad portion PDA1 may be located closer to the edge of the display panel 100 than the data driver 700.

The second pad portion PDA2 may include a plurality of second pads PD2 corresponding to inspection pads that test whether the display panel 100 operates normally. The plurality of second pads PD2 may be connected to a jig or a probe pin during an inspection process, or may be connected to a circuit board for inspection. The circuit board for inspection may be a printed circuit board including a rigid material or a flexible printed circuit board including a flexible material.

The second pad portion PDA2 may be located on a fourth side of the display area DAA. For example, the second pad portion PDA2 may be located on the other side of the display area DAA in the second direction DR2. The second pad portion PDA2 may be located outside the second distribution circuit 720 in the second direction DR2. That is, the second pad portion PDA2 may be located closer to the edge of the display panel 100 than the second distribution circuit 720.

The first distribution circuit 710 distributes data voltages applied through the first pad portion PDA1 to the plurality of data lines DL. For example, the first distribution circuit 710 may distribute the data voltages applied through one first pad PD1 of the first pad portion PDA1 to the P (P is a positive integer of 2 or more) data lines DL, and as a result, the number of the plurality of first pads PD1 may be reduced. The first distribution circuit 710 may be located on the third side of the display area DAA of the display panel 100. For example, the first distribution circuit 710 may be located on one side of the display area DAA in the second direction DR2. That is, the first distribution circuit 710 may be located on the lower side of the display area DAA.

The second distribution circuit 720 distributes signals applied through the second pad portion PDA2 to the scan driver 610, the emission driver 620, and the data lines DL. The second pad portion PDA2 and the second distribution circuit 720 may be configured to inspect the operation of each of the pixels PX in the display area DAA. The second distribution circuit 720 may be located on the fourth side of the display area DAA of the display panel 100. For example, the second distribution circuit 720 may be located on the other side of the display area DAA in the second direction DR2. That is, the second distribution circuit 720 may be located on the upper side of the display area DAA.

The display device 10 may include an active region that implements an image and a non-active region that is positioned outside the active region and does not implement an image. Here, the maximum width of the active region may be, e.g., 1.5 inches or less. Here, the maximum width may mean the longest lateral length that may be measured in the active region. For example, when the display device 10 has a quadrilateral shape, the above-described maximum width may correspond to the diagonal length of the display device 10.

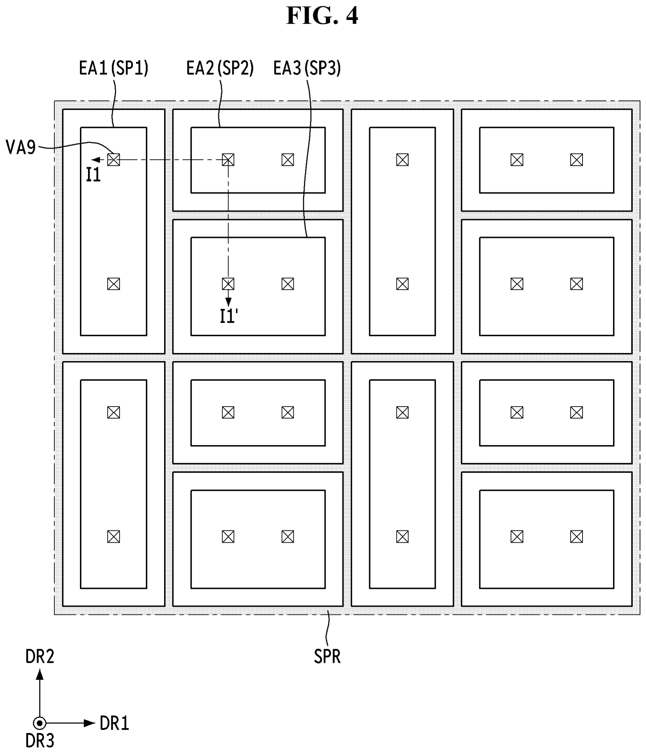

FIG. 4 is a layout diagram showing at least one example embodiment of the display area DAA of FIG. 3.

Referring to FIG. 4, each of the pixels PX includes a first emission area EA1 that is an emission area of the first sub-pixel area SP1, a second emission area EA2 that is an emission area of the second sub-pixel area SP2, and a third emission area EA3 that is an emission area of the third sub-pixel area SP3.

Each of the first emission area EA1, the second emission area EA2, and the third emission area EA3 may have a polygonal, circular, elliptical, or atypical shape in a plan view.

The maximum length of the first emission area EA1 in the first direction DR1 may be less than the maximum length of the second emission area EA2 in the first direction DR1 and the maximum length of the third emission area EA3 in the first direction DR1. The maximum length of the second emission area EA2 in the first direction DR1 and the maximum length of the third emission area EA3 in the first direction DR1 may be the same and/or substantially similar.

The maximum length of the first emission area EA1 in the second direction DR2 may be greater than the maximum length of the second emission area EA2 in the second direction DR2 and the maximum length of the third emission area EA3 in the second direction DR2. The maximum length of the second emission area EA2 in the second direction DR2 may be less than the maximum length of the third emission area EA3 in the second direction DR2. The maximum length of the first emission area EA1 in the second direction DR2 may be greater than the maximum length of the second emission area EA2 in the second direction DR2.

The first emission area EA1, the second emission area EA2, and the third emission area EA3 may have a polygonal shape other than a quadrangle, a circular shape, an elliptical shape, or an atypical shape in a plan view. In at least one example embodiment, the first emission area EA1, the second emission area EA2, and the third emission area EA3 may form a tessellated pattern.

As shown in FIG. 4, in each of the plurality of pixels PX, the first emission area EA1 and the second emission area EA2 may be adjacent to each other in the first direction DR1. Further, the first emission area EA1 and the third emission area EA3 may be adjacent to each other in the first direction DR1. In addition, the second emission area EA2 and the third emission area EA3 may be adjacent to each other in the second direction DR2. The area of the first emission area EA1, the area of the second emission area EA2, and the area of the third emission area EA3 may be different.

The first sub-pixel area SP1 may emit first light that has passed through a first color filter CF1 (see FIG. 5) among light emitted from the first emission area EA1, the second sub-pixel area SP2 may emit second light that has passed through a second color filter CF2 (see FIG. 5) among light emitted from the second emission area EA2, and the third sub-pixel area SP3 may emit third light that has passed through a third color filter CF3 (see FIG. 5) among light emitted from the third emission area EA3.

The first light, the second light, and the third light described above may be light of different wavelength bands. For example, one of the first to third light may be light of a green wavelength band, another light may be light of a red wavelength band, and the other light may be light of a blue wavelength band. Here, the blue wavelength band may be a wavelength band of light whose main peak wavelength is in the range of approximately 370 nm to 460 nm, the green wavelength band may be a wavelength band of light whose main peak wavelength is in the range of approximately 480 nm to 560 nm, and the red wavelength band may be a wavelength band of light whose main peak wavelength is in the range of approximately 600 nm to 750 nm.

It is illustrated in FIG. 4 that each of the plurality of pixels PX includes three emission areas EA1, EA2, and EA3, but the present disclosure is not limited thereto. That is, in at least one example embodiment, each of the plurality of pixels PX may include four emission areas.

In addition, the layout of the emission areas of the plurality of pixels PX is not limited to that shown in FIG. 4. For example, the emission areas of the plurality of pixels PX may be located in a stripe structure in which the emission areas are arranged in the first direction DR1, or a tessellated structure (e.g., a PenTile^{®} structure) in which the emission areas are arranged in a diamond shape.

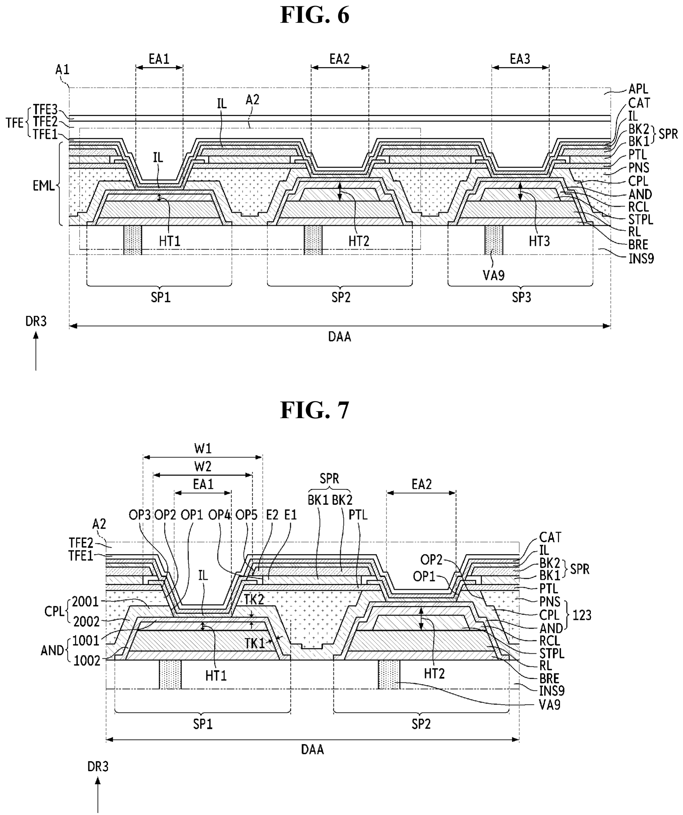

FIG. 5 is a cross-sectional view showing an example of a display panel taken along line I1-I1' of FIG. 4. FIG. 6 is a cross-sectional view showing area A1 of FIG. 5 in detail. FIG. 7 is a cross-sectional view showing area A2 of FIG. 6 in detail.

Referring to FIGS. 5 to 7, the display panel 100 includes a semiconductor backplane SBP, a light emitting element backplane EBP, a display element layer EML, an encapsulation layer TFE, an optical layer OPL, a cover layer CVL, and a polarizing plate POL.

The semiconductor backplane SBP includes the semiconductor substrate SSUB including a plurality of pixel transistors PTR, a plurality of semiconductor insulating layers covering the plurality of pixel transistors PTR, and a plurality of contact terminals CTE electrically connected to the plurality of pixel transistors PTR, respectively.

The semiconductor substrate SSUB may include an elemental semiconductor, and/or a compound semiconductor. For example, semiconductor substrate SSUB be a silicon substrate, a germanium substrate, or a silicon-germanium substrate. The semiconductor substrate SSUB may be a substrate doped with a first type impurity. A plurality of well regions WA may be located on the top surface of the semiconductor substrate SSUB. The plurality of well regions WA may be regions doped with a second type impurity. The second type impurity may be different from the aforementioned first type impurity. For example, when the first type impurity is a p-type impurity, the second type impurity may be an n-type impurity. Alternatively, when the first type impurity is an n-type impurity, the second type impurity may be a p-type impurity.

Each of the plurality of well regions WA includes a source region SA corresponding to the source electrode of the pixel transistor PTR, a drain region DA corresponding to the drain electrode, and a channel region CH located between the source region SA and the drain region DA.

A lower insulating layer BINS may be located between a gate electrode GE and the well region WA. A side insulating layer SINS may be located on the side surface of the gate electrode GE. The side insulating layer SINS may be located on the lower insulating layer BINS.

Each of the source region SA and the drain region DA may be a region doped with the first type impurity. The gate electrode GE of the pixel transistor PTR may overlap the well region WA in the third direction DR3, which is the thickness direction of the semiconductor substrate SSUB. The channel region CH may overlap the gate electrode GE in the third direction DR3. The source region SA may be located on one side of the gate electrode GE, and the drain region DA may be located on the other side of the gate electrode GE.

Each of the plurality of well regions WA further includes a first low-concentration impurity region LDD1 located between the channel region CH and the source region SA, and a second low-concentration impurity region LDD2 located between the channel region CH and the drain region DA. The first low-concentration impurity region LDD1 may be a region having a lower impurity concentration than the source region SA due to the lower insulating layer BINS. The second low-concentration impurity region LDD2 may be a region having a lower impurity concentration than the drain region DA due to the lower insulating layer BINS. For example, the lower insulating layer BINS may act as a shielding layer during a doping process, therein resulting in fewer dopants reaching the second low-concentration impurity region LDD2. The distance between the source region SA and the drain region DA may increase due to the presence of the first low-concentration impurity region LDD1 and the second low-concentration impurity region LDD2. Therefore, the length of the channel region CH of each of the pixel transistors PTR may increase, so that punch-through and hot carrier phenomena that might be caused by a short channel may be reduced or prevented.

A first semiconductor insulating layer SINS1 may be located on the semiconductor substrate SSUB. The first semiconductor insulating layer SINS1 may include an insulator comprising a semiconductor element with oxygen and/or nitrogen. For example, the first semiconductor insulating layer SINS1 may be formed as a silicon carbonitride (SiCN) and/or silicon oxide (SiOₓ)-based inorganic film, but the example embodiments of the present disclosure are not limited thereto.

A second semiconductor insulating layer SINS2 may be located on the first semiconductor insulating layer SINS1. The second semiconductor insulating layer SINS2 may include an insulator comprising a semiconductor element with oxygen and/or nitrogen. For example, the second semiconductor insulating layer SINS2 may be formed as a silicon oxide (SiOₓ)-based inorganic film, but the example embodiments of the present disclosure are not limited thereto.

The plurality of contact terminals CTE may be located on the second semiconductor insulating layer SINS2. Each of the plurality of contact terminals CTE may be connected to any one of the gate electrode GE, the source region SA, and the drain region DA of each of the pixel transistors PTR through holes penetrating the first semiconductor insulating layer SINS1 and the second semiconductor insulating layer SINS2. The plurality of contact terminals CTE may include any one of copper (Cu), aluminium (Al), tungsten (W), molybdenum (Mo), chromium (Cr), gold (Au), titanium (Ti), nickel (Ni), and neodymium (Nd), or an alloy including any one of them.

A third semiconductor insulating layer SINS3 may be located on a side surface of each of the plurality of contact terminals CTE. The top surface of each of the plurality of contact terminals CTE may be exposed without being covered by the third semiconductor insulating layer SINS3. The third semiconductor insulating layer SINS3 may include an insulator comprising a semiconductor element with oxygen and/or nitrogen. For example, the third semiconductor insulating layer SINS3 may be formed as a silicon oxide (SiOₓ)-based inorganic film, but the example embodiments of the present disclosure are not limited thereto.

In at least one example, the semiconductor substrate SSUB may be replaced with a glass substrate or a polymer resin substrate such as polyimide. In these cases, thin film transistors may be located on the glass substrate or the polymer resin substrate. The glass substrate may be a rigid substrate that does not bend, and the polymer resin substrate may be a flexible substrate that can be bent or curved.

The light emitting element backplane EBP includes a plurality of conductive layers ML1 to ML8, a plurality of via electrodes VA1 to VA9, and a plurality of insulating layers INS1 to INS9. In addition, the light emitting element backplane EBP includes the plurality of insulating layers INS1 to INS9 located between the first to eighth conductive layers ML1 to ML8.

The first to eighth conductive layers ML1 to ML8 serve to connect the plurality of contact terminals CTE exposed from the semiconductor backplane SBP to thereby implement the circuit of the first sub-pixel area SP1 shown in FIG. 3.

A first insulating layer INS1 may be located on the semiconductor backplane SBP. Each of the first via electrodes VA1 may penetrate the first insulating layer INS1 to be connected to the contact terminal CTE exposed from the semiconductor backplane SBP. Each of the first conductive layers ML1 may be located on the first insulating layer INS1 and may be connected to the first via electrode VA1.

A second insulating layer INS2 may be located on the first insulating layer INS1 and the first conductive layers ML1. Each of the second via electrodes VA2 may penetrate the second insulating layer INS2 and be connected to the exposed first conductive layer ML1. Each of the second conductive layers ML2 may be located on the second insulating layer INS2 and may be connected to the second via electrode VA2.

A third insulating layer INS3 may be located on the second insulating layer INS2 and the second conductive layers ML2. Each of the third via electrodes VA3 may penetrate the third insulating layer INS3 and be connected to the exposed second conductive layer ML2. Each of the third conductive layers ML3 may be located on the third insulating layer INS3 and may be connected to the third via electrode VA3.

A fourth insulating layer INS4 may be located on the third insulating layer INS3 and the third conductive layers ML3. Each of the fourth via electrodes VA4 may penetrate the fourth insulating layer INS4 and be connected to the exposed third conductive layer ML3. Each of the fourth conductive layers ML4 may be located on the fourth insulating layer INS4 and may be connected to the fourth via electrode VA4.

A fifth insulating layer INS5 may be located on the fourth insulating layer INS4 and the fourth conductive layers ML4. Each of the fifth via electrodes VA5 may penetrate the fifth insulating layer INS5 and be connected to the exposed fourth conductive layer ML4. Each of the fifth conductive layers ML5 may be located on the fifth insulating layer INS5 and may be connected to the fifth via electrode VA5.

A sixth insulating layer INS6 may be located on the fifth insulating layer INS5 and the fifth conductive layers ML5. Each of the sixth via electrodes VA6 may penetrate the sixth insulating layer INS6 and be connected to the exposed fifth conductive layer ML5. Each of the sixth conductive layers ML6 may be located on the sixth insulating layer INS6 and may be connected to the sixth via electrode VA6.

A seventh insulating layer INS7 may be located on the sixth insulating layer INS6 and the sixth conductive layers ML6. Each of the seventh via electrodes VA7 may penetrate the seventh insulating layer INS7 and be connected to the exposed sixth conductive layer ML6. Each of the seventh conductive layers ML7 may be located on the seventh insulating layer INS7 and may be connected to the seventh via electrode VA7.

An eighth insulating layer INS8 may be located on the seventh insulating layer INS7 and the seventh conductive layers ML7. Each of the eighth via electrodes VA8 may penetrate the eighth insulating layer INS8 and be connected to the exposed seventh conductive layer ML7. Each of the eighth conductive layers ML8 may be located on the eighth insulating layer INS8 and may be connected to the eighth via electrode VA8.

The first to eighth conductive layers ML1 to ML8 and the first to eighth via electrodes VA1 to VA8 may include the same and/or substantially similar and/or a substantially similar material. The first to eighth conductive layers ML1 to ML8 and the first to eighth via electrodes VA1 to VA8 may include an electrically conductive material. For example, the first to eighth conductive layers ML1 to ML8 and the first to eighth via electrodes VA1 to VA8 may include at least one of copper (Cu), aluminium (Al), tungsten (W), molybdenum (Mo), chromium (Cr), gold (Au), titanium (Ti), nickel (Ni), and neodymium (Nd), or an alloy including any one of them. Each of the first to eighth via electrodes VA1 to VA8 may include the same and/or substantially similar and/or a substantially similar material to the others. First to eighth insulating layers INS1 to INS8 may be formed as one or more insulator films, such as silicon oxide (SiOₓ)-based inorganic films, but the example embodiments of the present disclosure are not limited thereto.

The thicknesses of the first conductive layer ML1, the second conductive layer ML2, the third conductive layer ML3, the fourth conductive layer ML4, the fifth conductive layer ML5, and the sixth conductive layer ML6 may be greater than the thicknesses of the first via electrode VA1, the second via electrode VA2, the third via electrode VA3, the fourth via electrode VA4, the fifth via electrode VA5, and the sixth via electrode VA6, respectively. The thickness of each of the second conductive layer ML2, the third conductive layer ML3, the fourth conductive layer ML4, the fifth conductive layer ML5, and the sixth conductive layer ML6 may be greater than the thickness of the first conductive layer ML1. The thickness of the second conductive layer ML2, the thickness of the third conductive layer ML3, the thickness of the fourth conductive layer ML4, the thickness of the fifth conductive layer ML5, and the thickness of the sixth conductive layer ML6 may be the same and/or substantially similar and/or substantially similar. For example, the thickness of the first conductive layer ML1 may be approximately 1,360 angstrom (Å). The thickness of each of the second conductive layer ML2, the third conductive layer ML3, the fourth conductive layer ML4, the fifth conductive layer ML5, and the sixth conductive layer ML6 may be approximately 1,440 Å. The thickness of each of the first via electrode VA1, the second via electrode VA2, the third via electrode VA3, the fourth via electrode VA4, the fifth via electrode VA5, and the sixth via electrode VA6 may be approximately 1,150 Å.

The thickness of each of the seventh conductive layer ML7 and the eighth conductive layer ML8 may be greater than the thickness of each of the first conductive layer ML1, the second conductive layer ML2, the third conductive layer ML3, the fourth conductive layer ML4, the fifth conductive layer ML5, and the sixth conductive layer ML6. The thickness of the seventh conductive layer ML7 and the thickness of the eighth conductive layer ML8 may be greater than the thickness of the seventh via electrode VA7 and the thickness of the eighth via electrode VA8, respectively. The thickness of the seventh via electrode VA7 and the thickness of the eighth via electrode VA8 may each be greater than the thickness of the first via electrode VA1, the thickness of the second via electrode VA2, the thickness of the third via electrode VA3, the thickness of the fourth via electrode VA4, the thickness of the fifth via electrode VA5, and the thickness of the sixth via electrode VA6. The thickness of the seventh conductive layer ML7 and the thickness of the eighth conductive layer ML8 may be the same and/or substantially similar. For example, the thickness of each of the seventh conductive layer ML7 and the eighth conductive layer ML8 may be approximately 9,000 Å. The thickness of each of the seventh via electrode VA7 and the eighth via electrode VA8 may be approximately 6,000 Å.

A ninth insulating layer INS9 may be located on the eighth insulating layer INS8 and the eighth conductive layer ML8. The ninth insulating layer INS9 may be formed as a silicon oxide (SiOₓ)-based inorganic film, but the example embodiments of the present disclosure are not limited thereto.

Each of the ninth via electrodes VA9 may penetrate the ninth insulating layer INS9 and be connected to the exposed eighth conductive layer ML8. The ninth via electrodes VA9 may include an electrical conductor, for example at least one of copper (Cu), aluminium (Al), tungsten (W), molybdenum (Mo), chromium (Cr), gold (Au), titanium (Ti), nickel (Ni), and neodymium (Nd), or an alloy including any one of them. The thickness of the ninth via electrode VA9 may be approximately 16,500 Å.

The display element layer EML may be located on the light emitting element backplane EBP. The display element layer EML may include a plurality of barrier electrodes BRE, a plurality of reflective electrodes RL, an intermediate layer 123, a plurality of first electrodes AND, a light emitting stack layer IL, a second electrode CAT, and a bank layer SPR. Here, the intermediate layer 123 may include a plurality of capping layers CPL and a plurality of planarization layers PNS. Here, the intermediate layer 123 may further include a plurality of protective layers PTL in addition to the plurality of capping layers CPL and the plurality of planarization layers PNS. In addition, the bank layer SPR may include a first bank BK1 and a second bank BK2 on the first bank BK1.

Further, the display element layer EML may include the first emission area EA1, the second emission area EA2, and the third emission area EA3. Each of the first emission area EA1, the second emission area EA2, and the third emission area EA3 may be an area where the first electrode AND, the light emitting stack layer IL, and the second electrode CAT are sequentially stacked. Each of the first emission area EA1, the second emission area EA2, and the third emission area EA3 may be an area where the light emitting element LE including the first electrode AND, the light emitting stack layer IL, and the second electrode CAT is located. Each of the first emission area EA1, the second emission area EA2, and the third emission area EA3 may be partitioned by the capping layer CPL.

The plurality of barrier electrodes BRE may be located on the ninth insulating layer INS9. For example, the plurality of barrier electrodes BRE may be located on the ninth insulating layer INS9 to be respectively connected to the plurality of ninth via electrodes VA9. The barrier electrode BRE may protect against (e.g., prevent and/or reduce) a material (e.g., aluminium) included in the reflective electrode RL from being diffused. The plurality of barrier electrodes BRE may include titanium nitride (TiN) or transparent conductive oxide. For example, the transparent conductive oxide may be indium tin oxide (ITO) or indium zinc oxide (IZO), but the example embodiments of the present disclosure are not limited thereto.

The plurality of reflective electrodes RL may be respectively located on the plurality of barrier electrodes BRE. Each of the reflective electrodes RL may include at least one of copper (Cu), aluminium (Al), tungsten (W), molybdenum (Mo), chromium (Cr), gold (Au), titanium (Ti), nickel (Ni), and neodymium (Nd), or an alloy including any one of them. For example, each of the reflective electrodes RL may include aluminium (Al) with high reflectivity.

A step layer STPL may be located on the reflective electrode RL in each of the second sub-pixel areas SP2 and the third sub-pixel areas SP3. In some example embodiments, the step layer STPL may not be located in each of the first sub-pixel areas SP1. For example, the step layer STPL may be located between the reflective electrode RL and a resonance control layer RCL in the second sub-pixel area SP2 and the third sub-pixel area SP3 among the plurality of sub-pixel areas SP1, SP2, and SP3. The step layer STPL may be a layer (e.g., a step-causing layer) that causes a stepped portion (height difference) between the sub-pixel areas (e.g., SP1 and SP2) that emit light of different colors (or different wavelength bands). The step layer STPL may be formed as a silicon carbonitride (SiCN) or silicon oxide (SiOₓ)-based inorganic film, but the example embodiments of the present disclosure are not limited thereto.

The resonance control layers RCL may be respectively located on the reflective electrodes RL and the step layers STPL. The resonance control layer RCL may include an insulator. For example, the resonance control layer RCL be formed as a silicon oxide (SiOₓ)-based inorganic film, but the example embodiments of the present disclosure are not limited thereto.

In each of the first sub-pixel areas SP1, the resonance control layer RCL may be located on the reflective electrode RL. For example, in each of the first sub-pixel areas SP1, the resonance control layer RCL may cover the top surface of the reflective electrode RL.

In each of the second sub-pixel areas SP2, the resonance control layer RCL may be located on the reflective electrode RL and the step layer STPL. For example, in each of the second sub-pixel areas SP2, the resonance control layer RCL may cover the edge of the top surface of the reflective electrode RL, the top surface of the step layer STPL, and the side surface of the step layer STPL.

In each of the third sub-pixel areas SP3, the resonance control layer RCL may be located on the reflective electrode RL and the step layer STPL. For example, in each of the third sub-pixel areas SP3, the resonance control layer RCL may cover the edge of the top surface of the reflective electrode RL, the top surface of the step layer STPL, and the side surface of the step layer STPL.

Due to the step layer STPL, at least two of a height HT1 of the resonance control layer RCL in the first emission area EA1 of the first sub-pixel area SP1, a height HT2 of the resonance control layer RCL in the second emission area EA2 of the second sub-pixel area SP2, and a height HT3 of the resonance control layer RCL in the third emission area EA3 of the third sub-pixel area SP3 may be different from each other. For example, the height HT1 of the resonance control layer RCL in the first emission area EA1 may be the smallest. The height HT2 of the resonance control layer RCL in the second emission area EA2 may be greater than the height HT1 of the resonance control layer RCL in the first emission area EA1. On the other hand, the height HT3 of the resonance control layer RCL in the third emission area EA3 may be the same as the height HT2 of the resonance control layer RCL in the second emission area EA2. In this way, the height of the resonance control layer RCL in the first emission area EA1, the second emission area EA2, and the third emission area EA3 may vary depending on the thickness of the step layer and the number of the step layers. The height of the resonance control layer RCL may be set in consideration of the main peak wavelength of the first light, the main peak wavelength of the second light, the main peak wavelength of the third light, the distance from the first stack layer of the light emitting stack layer to the reflective electrode RL in the first emission area EA1, the distance from the second stack layer of the light emitting stack layer to the reflective electrode RL in the second emission area EA2, and the distance from the third stack layer of the light emitting stack layer to the reflective electrode RL in the third emission area EA3, so that the resonance distance of the first light, the resonance distance of the second light, and the resonance distance of the third light may be set.

Here, the height of the resonance control layer RCL in each of the emission areas EA1, EA2, and EA3 may be defined as the distance from the top surface of the reflective electrode RL to the top surface of the resonance control layer RCL in the corresponding emission area. For example, the height HT1 of the resonance control layer RCL in the first emission area EA1 described above may be defined as the distance (e.g., the distance in the third direction DR3) between the top surface (e.g., the interface between the reflective electrode RL and the resonance control layer RCL) of the reflective electrode RL and the top surface (e.g., the interface between the resonance control layer RCL and the first electrode AND) of the resonance control layer RCL in the first emission area EA1, the height HT2 of the resonance control layer RCL in the second emission area EA2 described above may be defined as the distance (e.g., the distance in the third direction DR3) between the top surface (e.g., the interface between the reflective electrode RL and the step layer STPL) of the reflective electrode RL and the top surface (e.g., the interface between the resonance control layer RCL and the first electrode AND) of the resonance control layer RCL in the second emission area EA2, and the height HT3 of the resonance control layer RCL in the third emission area EA3 described above may be defined as the distance (e.g., the distance in the third direction DR3) between the top surface (e.g., the interface between the reflective electrode RL and the step layer STPL) of the reflective electrode RL and the top surface (e.g., the interface between the resonance control layer RCL and the first electrode AND) of the resonance control layer RCL in the third emission area EA3. Since the step layer is not located in the first emission area EA1, the height HT1 of the resonance control layer RCL in the first emission area EA1 described above may be the same and/or substantially similar as the thickness of the resonance control layer RCL in the first emission area EA1.

The resonance control layer RCL may be located between the reflective electrode RL and a first electrode AND (e.g., an upper electrode portion 1001).

Each of the light emitting elements LE may include the first electrode AND, the light emitting stack layer IL, and the second electrode CAT.

The first electrode AND of each of the light emitting elements LE may be located on the side surface of the barrier electrode BRE, the side surface of the reflective electrode RL, the top surface of the resonance control layer RCL, and the side surface of the resonance control layer RCL. The first electrode AND of each of the light emitting elements LE may be in contact with and electrically connected to the side surface of the reflective electrode RL and the side surface of the barrier electrode BRE.

The first electrode AND may include the upper electrode portion 1001 located on the top surface of the resonance control layer RCL to overlap the top surface of the reflective electrode RL, and a side electrode portion 1002 extending from the upper electrode portion 1001 to the semiconductor substrate SSUB.

The side electrode portion 1002 of the first electrode AND may be located on the side surface of the resonance control layer RCL, the side surface of the reflective electrode RL, and the side surface of the barrier electrode BRE. The side surface of the resonance control layer RCL may be a surface that connects the top surface and the bottom surface of the resonance control layer RCL that face each other in the third direction DR3. Between the top surface and the bottom surface of the resonance control layer RCL, the top surface may be more distant from the semiconductor substrate SSUB, and between the top surface and the bottom surface of the resonance control layer RCL, the bottom surface may be closer to the semiconductor substrate SSUB. Further, the side surface of the reflective electrode RL may be a surface that connects the top surface and the bottom surface of the reflective electrode RL that face each other in the third direction DR3. Between the top surface and the bottom surface of the reflective electrode RL, the top surface may be more distant from the semiconductor substrate SSUB, and between the top surface and the bottom surface of the reflective electrode RL, the bottom surface may be closer to the semiconductor substrate SSUB. Further, the side surface of the barrier electrode BRE may be a surface that connects the top surface and the bottom surface of the barrier electrode BRE that face each other in the third direction DR3. Between the top surface and the bottom surface of the barrier electrode BRE, the top surface may be more distant from the semiconductor substrate SSUB, and between the top surface and the bottom surface of the barrier electrode BRE, the bottom surface may be closer to the semiconductor substrate SSUB.

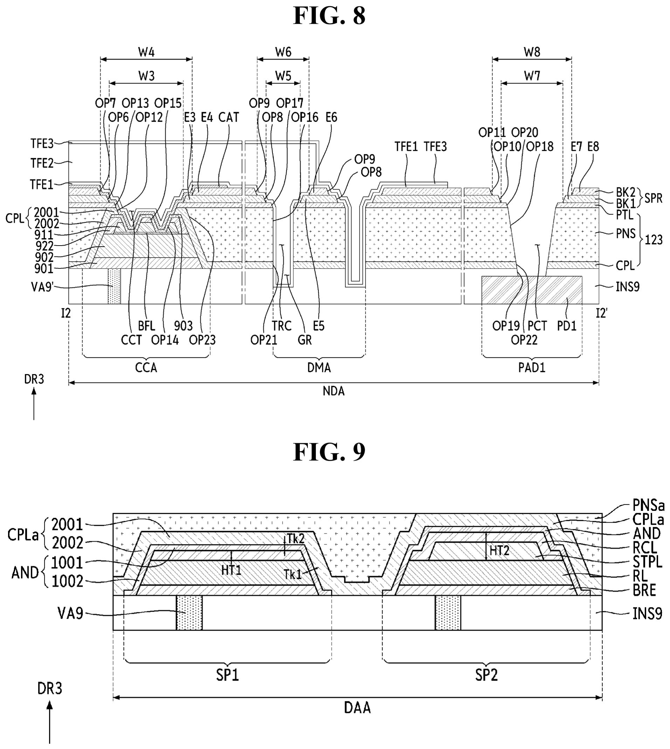

A thickness TK1 of the first electrode AND on the side surface of the resonance control layer RCL, the side surface of the reflective electrode RL, and the side surface of the barrier electrode BRE may be different from a thickness TK2 of the first electrode AND on the top surface of the resonance control layer RCL. For example, the thickness TK1 of the first electrode AND on the side surface of the resonance control layer RCL, the side surface of the reflective electrode RL, and the side surface of the barrier electrode BRE may be less than the thickness TK2 of the first electrode AND on the top surface of the resonance control layer RCL. As a specific example, as illustrated in FIG. 9, the thickness TK1 of the side electrode portion 1002 of the first electrode AND may be less than the thickness TK2 of the upper electrode portion 1001 of the first electrode AND. According to at least one example embodiment, the thickness TK1 of the side electrode portion 1002 may be approximately 65 Å, and the thickness TK2 of the upper electrode portion 1001 may be approximately 110 Å.

The first electrode AND of each of the light emitting elements LE may be connected to the drain region DA or the source region SA of the pixel transistor PTR through the barrier electrode BRE, the first to ninth via electrodes VA1 to VA9, the first to eighth conductive layers ML1 to ML8, and the contact terminal CTE.

The first electrodes AND of the sub-pixel areas SP1, SP2, and SP3 may be disconnected without being connected to each other. For example, the side electrode portion 1002 of the first electrode AND located in the first sub-pixel area SP1 may be spaced apart from the side electrode portion 1002 of the first electrode AND located in the second sub-pixel area SP2, and the side electrode portion 1002 of the first electrode AND located in the second sub-pixel area SP2 may be spaced apart from the side electrode portion 1002 of the first electrode AND located in the third sub-pixel area SP3. In other words, when a structure including the plurality of first electrodes AND located in the plurality of sub-pixel areas SP1, SP2, and SP3 is defined as one first electrode structure, the first electrode structure may be disconnected between adjacent sub-pixel areas SP1, SP2, and SP3. The first electrode AND of each of the light emitting elements LE may include a conductive material, such as at least one of copper (Cu), aluminium (Al), tungsten (W), molybdenum (Mo), chromium (Cr), gold (Au), titanium (Ti), nickel (Ni), and neodymium (Nd), or an alloy including any one of them. For example, in at least one example, the first electrode AND of each of the light emitting elements LE may be titanium nitride (TiN).

The intermediate layer 123 may be located on the first electrodes AND. The intermediate layer 123 may have a first opening portion overlapping the first electrode AND in each of the sub-pixel areas SP1, SP2, and SP3 of the display area DAA; a second opening portion overlapping a third power connection electrode 903 in a power connection area CCA of the non-display area NDA; a third opening portion located in a dam area DMA of the non-display area NDA; and a fourth opening portion overlapping the first pad PD1 in a first pad area PAD1 of the non-display area NDA. Here, the first opening portion of the intermediate layer 123 may include a plurality of openings OP1, OP2, and OP3 respectively overlapping the first electrode AND; the second opening of the intermediate layer 123 may include a plurality of openings OP12, OP23, and OP13 overlapping the third power connection electrode 903; the third opening of the intermediate layer 123 may include a plurality of openings OP21, OP16, and OP17 respectively forming a portion of a trench TRC; and the fourth opening of the intermediate layer 123 may include a plurality of openings OP22, OP18, and OP20 overlapping the first pad PD1. This intermediate layer 123 may include the capping layer CPL, the planarization layer PNS, and the protective layer PTL, as stated above.

The capping layer CPL may partition the first emission areas EA1, the second emission areas EA2, and the third emission areas EA3. The capping layer CPL may be located on a part of the first electrode AND of each of the light emitting elements LE. The capping layer CPL may cover the edge of the first electrode AND of each of the light emitting elements LE. For example, the capping layer CPL may have a plurality of first openings OP1 respectively defining the plurality of emission areas EA1, EA2, and EA3. The first opening OP1 of the first emission area EA1 may penetrate the capping layer CPL to overlap the first electrode AND (e.g., the upper electrode portion 1001) of the first emission area EA1, the first opening OP1 of the second emission area EA2 may penetrate the capping layer CPL to overlap the first electrode AND (e.g., the upper electrode portion 1001) of the second emission area EA2, and the first opening OP1 of the third emission area EA3 may penetrate the capping layer CPL to overlap the first electrode AND (e.g., the upper electrode portion 1001) of the third emission area EA3. The capping layer CPL may include a material containing silicon nitride (SiNx). In some example embodiments, the capping layer CPL may include a material different from that of the planarization layer PNS to be described later, so that the planarization layer PNS may function as an etch stop film that defines the thickness (or height) of the planarization layer PNS when the planarization layer PNS is removed by chemical mechanical polishing (CMP).

In at least some example embodiments, the capping layer CPL may be in contact (e.g., in direct contact) with the first electrode AND. The capping layer CPL may be located on the first electrode AND. For example, the capping layer CPL may be located on the top surface of the first electrode AND and the side surface of the first electrode AND. In these cases, the capping layer CPL may be located on the edge of the top surface of the first electrode AND. The capping layer CPL may include an upper capping portion 2001 located on the upper electrode portion 1001 of the first electrode AND and a side capping portion 2002 located on the side electrode portion 1002 of the first electrode AND.

The first emission area EA1 may be defined as the area in which the first electrode AND, the light emitting stack layer IL, and the second electrode CAT are sequentially stacked in the first sub-pixel area SP1 to emit light. The second emission area EA2 may be defined as the area in which the first electrode AND, the light emitting stack layer IL, and the second electrode CAT are sequentially stacked in the second sub-pixel area SP2 to emit light. The third emission area EA3 may be defined as the area in which the first electrode AND, the light emitting stack layer IL, and the second electrode CAT are sequentially stacked in the third sub-pixel area SP3 to emit light.

The planarization layer PNS may be a planarization layer capable of planarizing the stepped portion between the sub-pixel areas SP1, SP2, and SP3 caused by the step layer STPL. The planarization layer PNS may be located on the capping layer CPL. For example, the planarization layer PNS may be located on the top surface and the side surface of the capping layer CPL. In these cases, the planarization layer PNS may be in contact (e.g., in direct contact) with the capping layer CPL, and may be in contact (or in direct contact) with the first electrode AND. Further, the planarization layer PNS may include a second opening OP2 penetrating the planarization layer PNS in the third direction DR3. The second opening OP2 of the planarization layer PNS may overlap the first opening OP1 of the capping layer CPL. In other words, the plurality of second openings OP2 of the planarization layer PNS may respectively overlap the emission areas EA1, EA2, and EA3 of the capping layer CPL. The planarization layer PNS may include a material containing silicon oxide (SiOx).

The protective layer PTL may be located on the planarization layer PNS and the capping layer CPL. The protective layer PTL may have the third opening OP3 that penetrates the protective layer PTL in the third direction DR3. The third opening OP3 of the protective layer PTL may overlap the first opening OP1, the second opening OP2, and the emission area EA. The protective layer PTL may include the same material as the planarization layer PNS. For example, the protective layer PTL may include a material containing silicon oxide (SiOx). In these cases, the protective layer PTL and the planarization layer PNS may be formed integrally (e.g., without an interface).

The bank layer SPR may be located on the intermediate layer 123. The bank layer SPR may have a fifth opening portion overlapping the first opening portion of the intermediate layer 123 and the first electrode AND in each of the sub-pixel areas SP1, SP2, and SP3 of the display area DAA; a sixth opening portion overlapping the second opening portion of the intermediate layer 123 and the third power connection electrode 903 in the power connection area CCA of the non-display area NDA; a seventh opening portion overlapping the third opening portion of the intermediate layer 123 in the dam area DMA of the non-display area NDA; and an eighth opening portion overlapping the fourth opening portion of the intermediate layer 123 and the first pad PD1 in the first pad area PAD1 of the non-display area NDA. Here, the fifth opening portion of the bank layer SPR may include a plurality of openings OP4 and OP5 overlapping the first electrode AND and the first opening portion of the intermediate layer 123; the sixth opening portion of the bank layer SPR may include a plurality of openings OP6 and OP7 overlapping the third power connection electrode 903 and the second opening portion of the intermediate layer 123; the seventh opening portion of the bank layer SPR may include a plurality of openings OP8 and OP9 overlapping the third opening portion of the intermediate layer 123; and the eighth opening portion of the bank layer SPR may include a plurality of openings OP10 and OP11 overlapping the first pad PD1 and the fourth opening portion of the intermediate layer 123. This bank layer SPR may include the first bank BK1 and the second bank BK2, as stated above.

The bank layer SPR may be located on the protective layer PTL. In a plan view, as illustrated in FIG. 4, the bank layer SPR may have a shape of a mesh surrounding each of the emission areas EA1, EA2, and EA3. The bank layer SPR may be located on the protective layer PTL to surround each of the emission areas EA1, EA2, and EA3. However, the present disclosure is not limited thereto, and a plurality of bank layers may surround the plurality of emission areas EA1, EA2, and EA3, respectively. In these cases, each bank layer may have a closed curve shape. The bank layer SPR may be a structure for cutting the light emitting stack layer IL. To this end, according to at least one example embodiment, the bank layer SPR may include the first bank BK1 and the second bank BK2 having different areas.

The first bank BK1 may be located on the protective layer PTL. The first bank BK1 may be located on the protective layer PTL in such a manner as to overlap the capping layer CPL. Here, the area of the first bank BK1 may be smaller than the area of the protective layer PTL. For example, in a plan view, the area of the first bank BK1 may be less than the area of the protective layer PTL so that the first bank BK1 may be surrounded by the edge of the protective layer PTL. Additionally, the first bank BK1 may have the fourth opening OP4 that penetrates the first bank BK1. The fourth opening OP4 of the first bank BK1 may overlap the first opening OP1, the second opening OP2, the third opening OP3, and the emission area (e.g., the first emission area EA1.

The second bank BK2 may be located on the first bank BK1. The second bank BK2 may be located on the first bank BK1 to overlap the first bank BK1. In these cases, in the display area DAA, the area of the second bank BK2 may be greater than the area of the first bank BK1. For example, in a plan view, the area of the second bank BK2 may be larger than the area of the first bank BK1 in the display area DAA so that the second bank BK2 of the display area DAA may surround the edge of the first bank BK1 of the display area DAA. In addition, the second bank BK2 may have the fifth opening OP5 that penetrates the second bank BK2. The fifth opening OP5 of the second bank BK2 may overlap the first opening OP1, the second opening OP2, the third opening OP3, the fourth opening OP4, and the emission area (e.g., the first emission area EA1). The etching rate of the first bank BK1 may be different from the etching rate of the second bank BK2. For example, the etching rate of the first bank BK1 may be greater than the etching rate of the second bank BK2. In at least one example embodiments, the first bank BK1 may include a material including at least one of titanium (Ti), tantalum (Ta), or molybdenum (Mo); and/or the second bank BK2 may include a material containing silicon oxide (SiOx).

In a direction parallel to the semiconductor substrate SSUB, an edge E2 of the second bank BK2 of the sub-pixel area (e.g., the first sub-pixel area EA1) may extend beyond an edge E1 of the first bank BK1 toward the first opening OP1 of the capping layer CPL. Accordingly, a width W1 of the fourth opening OP4 of the first bank BK1 of the display area DAA (or sub-pixel area) may be larger than a width W2 of the fifth opening OP5 of the second bank BK2. Thereby, the bank layer SPR may be referred to as having an undercut structure in the sub-pixel area. In a plan view, the fourth opening OP4 of the first bank BK1 of each of the sub-pixel areas SP1, SP2, and SP3 may surround the fifth opening OP5 of the second bank BK2.

The light emitting stack layer IL may be located on the first electrodes AND, the capping layer CPL, and the bank layer SPR. In these cases, the light emitting stack layer IL may be cut on the bank layers SPR. For example, the light emitting stack layer IL may be cut between the protective layer PTL and the second bank BK2. In cross-sectional view, the light emitting stack layer IL may be cut along the bank layer SPR. Therefore, the light emitting stack layer IL may be divided into a portion in contact with the first electrode AND in the emission area and a portion located on an area other than the emission area (e.g., the second bank BK2 of the bank layer SPR). In other words, the light emitting stack layer IL may be cut along the bank layer SPR to be separated for each sub-pixel area. Accordingly, the lateral leakage current between adjacent sub-pixel areas SP1, SP2, and SP3 may be reduced and/or minimized. Since the lateral leakage current is reduced, the color mixing phenomenon between adjacent sub-pixel areas SP1, SP2, and SP3 may be protected against, thereby improving the image quality of the display device 10.

The light emitting stack layer IL may include a plurality of stack layers sequentially stacked along the third direction DR3. For example, the light emitting stack layer IL may have a three-tandem structure including a first stack layer, a second stack layer on the first stack layer, and a third stack layer on the second stack layer. Here, the second stack layer may be located between the first stack layer and the third stack layer. The example embodiments of the present disclosure are not limited thereto. For example, the light emitting stack layer IL may have a two-tandem structure including two stack layers.

In the three-tandem structure, the first stack layer, the second stack layer, and the third stack layer of the light emitting stack layer IL may provide light of different colors (or wavelengths). For example, one of the first stack layer, the second stack layer, and the third stack layer may provide light of a first color (e.g., green), another stack layer may provide light of a second color (e.g., red), and the other stack layer may provide light of a third color (e.g., blue).

The first stack layer of the light emitting stack layer IL may have a structure in which a first hole transporting layer, a first organic light emitting layer, and a first electron transporting layer are sequentially stacked. The second stack layer of the light emitting stack layer IL may have a structure in which a second hole transporting layer, a second organic light emitting layer, and a second electron transporting layer are sequentially stacked. The third stack layer of the light emitting stack layer IL may have a structure in which a third hole transporting layer, a third organic light emitting layer, and a third electron transporting layer are sequentially stacked. Here, the first organic light emitting layer, the second organic light emitting layer, and the third organic light emitting layer may provide light of different colors (or wavelengths). For example, one organic light emitting layer from among the first organic light emitting layer, the second organic light emitting layer, and the third organic light emitting layer may provide light of the first color (e.g., green), another organic light emitting layer may provide light of the second color (e.g., red), and the remaining organic light emitting layer may provide light of the third color (e.g., blue).

A first charge generation layer for supplying charges to the second stack layer and supplying electrons to the first stack layer may be located between the first stack layer and the second stack layer. The first charge generation layer may include an n-type charge generation layer that supplies electrons to the first stack layer and a p-type charge generation layer that supplies holes to the second stack layer. The n-type charge generation layer may include a dopant of a metal material.

A second charge generation layer for supplying charges to the third stack layer and supplying electrons to the second stack layer may be located between the second stack layer and the third stack layer. The second charge generation layer may include an n-type charge generation layer that supplies electrons to the second stack layer and a p-type charge generation layer that supplies holes to the third stack layer.

The first stack layer may be located on the first electrodes AND and the capping layer CPL. The first stack layer of the light emitting stack layer IL may be disconnected between the sub-pixel areas SP1, SP2, and SP3 adjacent to each other by the above-described bank layer SPR. The second stack layer of the light emitting stack layer IL may be located on the first stack layer. The second stack layer of the light emitting stack layer IL may be disconnected between the sub-pixel areas SP1, SP2, and SP3 adjacent to each other by the above-described bank layer SPR. The third stack layer of the light emitting stack layer IL may be located on the second stack layer. The third stack layer of the light emitting stack layer IL may not be disconnected by the bank layer SPR, and may be located to cover the second stack layer.

In the three-tandem structure, the bank layer SPR may be a structure for disconnecting the first charge generation layer and the second charge generation layer of the display element layer EML between the sub-pixel areas SP1, SP2, and SP3 adjacent to each other. Further, in the two-tandem structure, the bank layer SPR may be a structure for disconnecting the charge generation layer located between the lower stack layer and the upper stack layer.

The second electrode CAT may be located on the light emitting stack layer IL. For example, the second electrode CAT may be located on the third stack layer of the light emitting stack layer IL. The second electrode CAT may be located on the third stack layer of the light emitting stack layer IL without being disconnected by the bank layer SPR. The second electrode CAT may include a transparent conductive material (TCO), or a semi-transmissive conductive material such as magnesium (Mg), silver (Ag), or an alloy of magnesium (Mg) and silver (Ag). In these cases, light emission efficiency in each of the first to third sub-pixel areas SP1, SP2, and SP3 may be increased due to a micro-cavity effect.

The encapsulation layer TFE may be located on the display element layer EML. The encapsulation layer TFE may include at least one inorganic layer (e.g., acryl resin, epoxy resin, phenolic resin, polyamide resin, polyimide resin, and/or the like) selected to protect against oxygen or moisture permeating into the display element layer EML. For example, the encapsulation layer TFE may include a first encapsulation layer TFE1, a second encapsulation layer TFE2, and a third encapsulation layer TFE3.

The first encapsulation layer TFE1 may be disposed on the second electrode CAT. The first encapsulation layer TFE1 may be formed as a multilayer in which one or more inorganic films selected from silicon nitride (SiNx), silicon oxy nitride (SiON), and/or silicon oxide (SiOx) are alternately stacked. The first encapsulation layer TFE1 may be formed by a chemical vapor deposition (CVD) process.

The second encapsulation layer TFE2 may be and/or include a monomer. Alternatively, the second encapsulation layer TFE2 may be an organic film such as acryl resin, epoxy resin, phenolic resin, polyamide resin, polyimide resin, or the like.

The third encapsulation layer TFE3 may be disposed on the second encapsulation layer TFE2. The third encapsulation layer TFE3 may be formed as a multilayer in which one or more inorganic films selected from silicon nitride (SiNx), silicon oxy nitride (SiON), and silicon oxide (SiOx) are alternately stacked. The third encapsulation layer TFE3 may be formed by a chemical vapor deposition (CVD) process.

An organic layer APL may be a layer for increasing the interfacial adhesion between the encapsulation layer TFE and the optical layer OPL. The organic layer APL may be an organic film such as acrylic resin, epoxy resin, phenolic resin, polyamide resin, or polyimide resin.

The optical layer OPL includes a plurality of color filters CF1, CF2, and CF3, a plurality of lenses LNS, and a filling layer FIL. The plurality of color filters CF1, CF2, and CF3 may include the first to third color filters CF1, CF2, and CF3. The first to third color filters CF1, CF2, and CF3 may be located on the adhesive layer ADL.

The first color filter CF1 may overlap the first emission area EA1 of the first sub-pixel area SP1. The first color filter CF1 may transmit the first light (e.g., light of a green wavelength band). Thus, the first color filter CF1 may transmit the first light among light emitted from the light emitting stack layer IL of the first emission area EA1.

The second color filter CF2 may overlap the second emission area EA2 of the second sub-pixel area SP2. The second color filter CF2 may transmit the second light (e.g., light of a red wavelength band). Thus, the second color filter CF2 may transmit the second light among light emitted from the light emitting stack layer IL of the second emission area EA2.

The third color filter CF3 may overlap the third emission area EA3 of the third sub-pixel area SP3. The third color filter CF3 may transmit the third light (e.g., light of a blue wavelength band). Thus, the third color filter CF3 may transmit the third light among light emitted from the light emitting stack layer IL of the third emission area EA3.

The plurality of lenses LNS may be located on the first color filter CF1, the second color filter CF2, and the third color filter CF3, respectively. Each of the plurality of lenses LNS may be a structure for increasing the proportion of light directed to the front of the display device 10. Although each of the lenses LNS is illustrated as having a cross-sectional shape that is convex upward, the example embodiments of the present disclosure are not limited thereto.

The filling layer FIL may be located on the plurality of lenses LNS. The filling layer FIL may have a selected refractive index such that light travels in the third direction DR3 at an interface between the filling layer FIL and the plurality of lenses LNS. Further, the filling layer FIL may be a planarization layer. The filling layer FIL may be an organic film such as acrylic resin, epoxy resin, phenolic resin, polyamide resin, or polyimide resin.

The cover layer CVL may be located on the filling layer FIL. The cover layer CVL may be a glass substrate or a polymer resin. When the cover layer CVL is a glass substrate, it may be attached onto the filling layer FIL. In these cases, the filling layer FIL may serve to bond the cover layer CVL. When the cover layer CVL is a glass substrate, it may serve as an encapsulation substrate. When the cover layer CVL is a polymer resin, it may be directly applied onto the filling layer FIL.

The polarizing plate POL may be located on one surface of the cover layer CVL. The polarizing plate POL may be a structure for reducing or preventing visibility degradation caused by reflection of external light. The polarizing plate POL may include a linear polarizing plate and a phase retardation film. For example, the phase retardation film may be a λ/4 plate (quarter-wave plate), but the example embodiments of the present disclosure are not limited thereto. However, when visibility degradation caused by reflection of external light is sufficiently overcome by the first to third color filters CF1, CF2, and CF3, the polarizing plate POL may be omitted.

FIG. 8 is a cross-sectional view illustrating an example of the display panel 100 taken along line I1-I1' of FIG. 3.

Referring to FIG. 8, the power connection area CCA, the dam area DMA, and the pad area PAD1 (e.g., the first pad area PAD1) may be arranged on the non-display area NDA of the semiconductor substrate SSUB.

A first power connection electrode 901, a second power connection electrode 902, a buffer layer BFL, a first auxiliary layer 911, a second auxiliary layer 922, the third power connection electrode 903, and the capping layer CPL may be arranged in the power connection area CCA.

The first power connection electrode 901 may be located on the ninth insulating layer INS9. The first power connection electrode 901 may be connected to a power line on the semiconductor substrate SSUB through a ninth via electrode VA9'. The power line may be connected to, for example, the power supply circuit 500 to be supplied with power (e.g., the first driving voltage VSS). The first power connection electrode 901 may include the same material as the barrier electrode BRE described above.

The second power connection electrode 902 may be located on the first power connection electrode 901. The second power connection electrode 902 may include the same material as the reflective electrode RL described above.

The buffer layer BFL may be located on the second power connection electrode 902. The buffer layer BFL may be located on the top surface of the second power connection electrode 902. The buffer layer BFL may be in contact (or direct contact) with the second power connection electrode 902. The buffer layer BFL may protect against formation of an oxide layer on the second power connection electrode 902. Since the second power connection electrode 902 and the third power connection electrode 903 are connected to each other through the buffer layer BFL, the contact resistance between the second power connection electrode 902 and the third power connection electrode 903 may be reduced. The buffer layer BFL may include titanium nitride (TiN). The buffer layer BFL may have a thickness of about 10 Å or less.

The first auxiliary layer 911 may be located on the buffer layer BFL. The first auxiliary layer 911 may have a fourteenth opening OP14 that penetrates the first auxiliary layer 911 in the third direction DR3. The fourteenth opening OP14 of the first auxiliary layer 911 may overlap the buffer layer BFL. The first auxiliary layer 911 may include the same material as the step layer STPL described above.

The second auxiliary layer 922 may be located on the first auxiliary layer 911 and the second power connection electrode 902. The second auxiliary layer 922 may have a fifteenth opening OP15 that penetrates the second auxiliary layer 922 in the third direction DR3. The fifteenth opening OP15 of the second auxiliary layer 922 may overlap the fourteenth opening OP14 of the first auxiliary layer 911 and the buffer layer BFL. The second auxiliary layer 922 may include the same material as the resonance control layer RCL described above.

The third power connection electrode 903 may be located on the second auxiliary layer 922. The third power connection electrode 903 may have an uneven structure. The third power connection electrode 903 may be connected to the buffer layer BFL through the fifteenth opening OP15 of the second auxiliary layer 922 and the fourteenth opening OP14 of the first auxiliary layer 911. The third power connection electrode 903 may include the same material as the first electrode AND described above.

The capping layer CPL described above may further include the twelfth opening OP12 that penetrates the capping layer CPL in the third direction DR3 in the power connection area CCA. The twelfth opening OP12 of the capping layer CPL may overlap the third power connection electrode 903, the fifteenth opening OP15 of the second auxiliary layer 922, the fourteenth opening OP14 of the first auxiliary layer 911, and the buffer layer BFL.

The protective layer PTL described above may further include the thirteenth opening OP13 that penetrates the protective layer PTL in the third direction DR3 in the power connection area CCA. The thirteenth opening OP13 of the protective layer PTL may overlap the twelfth opening OP12 of the capping layer CPL, the third power connection electrode 903, the fifteenth opening OP15 of the second auxiliary layer 922, the fourteenth opening OP14 of the first auxiliary layer 911, and the buffer layer BFL.

The above-described first bank BK1 may further include a sixth opening OP6 that penetrates the first bank BK1 in the third direction DR3 in the power connection area CCA. The sixth opening OP6 of the first bank BK1 may overlap the thirteenth opening OP13 of the protective layer PTL, the twelfth opening OP12 of the capping layer CPL, the third power connection electrode 903, the fifteenth opening OP15 of the second auxiliary layer 922, the fourteenth opening OP14 of the first auxiliary layer 911, and the buffer layer BFL.

The above-described second bank BK2 may further include a seventh opening OP7 that penetrates the second bank BK2 in the third direction DR3 in the power connection area CCA. The seventh opening OP7 of the second bank BK2 may overlap the sixth opening OP6 of the first bank BK1, the thirteenth opening OP13 of the protective layer PTL, the twelfth opening OP12 of the capping layer CPL, the third power connection electrode 903, the fifteenth opening OP15 of the second auxiliary layer 922, the fourteenth opening OP14 of the first auxiliary layer 911, and the buffer layer BFL.

The above-described second electrode CAT may be connected to the third power connection electrode 903 through a power contact hole CCT of the power connection area CCA. The power contact hole CCT may include the twelfth opening OP12 of the capping layer CPL and the thirteenth opening OP13 of the protective layer PTL. The second electrode CAT may be connected to the third power connection electrode 903 through the seventh opening OP7 of the second bank BK2, the sixth opening OP6 of the first bank BK1, and the power contact hole CCT (e.g., the thirteenth opening OP13 of the protective layer PTL and the twelfth opening OP12 of the capping layer CPL).

In a direction parallel to the semiconductor substrate SSUB, an edge E3 of the first bank BK1 of the power connection area CCA may extend beyond an edge E4 of the second bank BK2 toward the thirteenth opening OP13 of the protective layer PTL. Thereby, the bank layer SPR may be referred to as having a step-shaped structure and/or a non-undercut structure in the power connection area CAA above the thirteenth opening OP 13. Accordingly, a width W3 of the sixth opening OP6 included in the first bank BK1 of the power connection area CCA may be smaller than a width W4 of the seventh opening OP7 included in the second bank BK2. In a plan view, the sixth opening OP6 of the first bank BK1 of the power connection area CCA may be surrounded by the seventh opening OP7 of the second bank BK2.

The trench TRC may be located in the dam area DMA. The ninth insulating layer INS9 may be exposed by the trench TRC.

The trench TRC may include a groove GR located in the ninth insulating layer INS9 in the dam area DMA, the twenty-first opening OP21 that penetrates the capping layer CPL in the third direction DR3 in the dam area DMA, the sixteenth opening OP16 that penetrates the planarization layer PNS in the third direction DR3 in the dam area DMA, and the seventeenth opening OP17 that penetrates the protective layer PTL in the third direction DR3 in the dam area DMA. Here, the groove GR, the twenty-first opening OP21, the sixteenth opening OP16, and the seventeenth opening OP17 may overlap each other.

The first bank BK1 described above may further include the eighth opening OP8 that penetrates the first bank BK1 in the third direction DR3 in the dam area DMA. The eighth opening OP8 of the first bank BK1 may overlap the groove GR, the twenty-first opening OP21, the sixteenth opening OP16, and the seventeenth opening OP17.

The second bank BK2 described above may further include the ninth opening OP9 that penetrates the second bank BK2 in the third direction DR3 in the dam area DMA. The ninth opening OP9 of the second bank BK2 may overlap the eighth opening OP8 of the first bank BK1, the seventeenth opening OP17 of the protective layer PTL, and the groove GR.

In a direction parallel to the semiconductor substrate SSUB, an edge E5 of the first bank BK1 of the dam area DMA may extend beyond an edge E6 of the second bank BK2 toward the seventeenth opening OP17 of the protective layer PTL. Thereby, the bank layer SPR may be referred to as having a step-shaped structure and/or a non-undercut structure in the dam area DMA above the seventeenth opening OP 17. Accordingly, a width W5 of the eighth opening OP8 included in the first bank BK1 of the dam area DMA may be smaller than a width W6 of the ninth opening OP9 included in the second bank BK2. In a plan view, the eighth opening OP8 of the first bank BK1 of the dam area DMA may be surrounded by the ninth opening OP9 of the second bank BK2.

A pad contact hole PCT may be located in the first pad area PAD1. The first pad PD1 may be exposed by the pad contact hole PCT.

The pad contact hole PCT may include a nineteenth opening OP19 that penetrates the ninth insulating layer INS9 in the third direction DR3 in the first pad area PAD1, the twenty-second opening OP22 that penetrates the capping layer CPL in the third direction DR3 in the first pad area PAD1, the eighteenth opening OP18 that penetrates the planarization layer PNS in the third direction DR3 in the first pad area PAD1, and the twentieth opening OP20 that penetrates the protective layer PTL in the third direction DR3 in the first pad area PAD 1. Here, the nineteenth opening OP19, the twenty-second opening OP22, the eighteenth opening OP18, and the twentieth opening OP20 may overlap each other.

The first bank BK1 described above may further include the tenth opening OP10 that penetrates the first bank BK1 in the third direction DR3 in the first pad area PAD1. The tenth opening OP10 of the first bank BK1 may overlap the nineteenth opening OP19, the twenty-second opening OP22, the eighteenth opening OP18, and the twentieth opening OP20.

The second bank BK2 described above may further include the eleventh opening OP11 that penetrates the second bank BK2 in the third direction DR3 in the first pad area PAD 1. The eleventh opening OP11 of the second bank BK2 may overlap the tenth opening OP10, the nineteenth opening OP19, the twenty-second opening OP22, the eighteenth opening OP18, and the twentieth opening OP20.

In a direction parallel to the semiconductor substrate SSUB, an edge E7 of the first bank BK1 of the first pad area PAD1 may extend beyond an edge E8 of the second bank BK2 toward the twentieth opening OP20 of the protective layer PTL. Thereby, the bank layer SPR may be referred to as having a step-shaped structure and/or a non-undercut structure in the first pad area PAD1 above the twentieth opening OP20. Accordingly, a width W7 of the tenth opening OP10 included in the first bank BK1 of the first pad area PAD1 may be smaller than a width W8 of the eleventh opening OP11 included in the second bank BK2. In a plan view, the tenth opening OP10 of the first bank BK1 of the first pad area PAD1 may be surrounded by the eleventh opening OP11 of the second bank BK2.

The first encapsulation layer TFE1 may be located in the power connection area CCA and the dam area DMA. In these cases, the first encapsulation layer TFE1 may be located in the trenches TRC of the dam area DMA. For example, when the trench TRC located closer to the power connection area CCA among the two trenches TRC of FIG. 8 is defined as the first trench TRC, and the trench TRC between the first trench TRC and the first pad area PAD1 is defined as the second trench TRC, the first encapsulation layer TFE1 may be located within the first trench TRC and the second trench TRC.

The second encapsulation layer TFE2 may be located in the power connection area CCA and the dam area DMA. In these cases, the second encapsulation layer TFE2 may be located within the trench TRC of the dam area DMA. For example, the second encapsulation layer TFE2 may be located within the aforementioned first trench TRC.

The third encapsulation layer TFE3 may be located in the power connection area CCA and the dam area DMA. In these cases, the third encapsulation layer TFE3 may be located within the trench TRC of the dam area DMA. For example, the third encapsulation layer TFE3 may be located within the aforementioned second trench TRC.

The first encapsulation layer TFE1 and the third encapsulation layer TFE3 may be further located on the second bank BK2 between the outermost trench (e.g., the second trench TRC) and the first pad area PAD1. In these cases, the first encapsulation layer TFE1 and the third encapsulation layer TFE3 may be in contact (or direct contact) with each other on the second bank BK2 between the second trench TRC and the first pad area PAD1.

The second electrode CAT may be connected to the third power connection electrode 903 through the power contact hole CCT. According to at least one example embodiment, since the width of the second bank BK2 is smaller than the width of the first bank BK1 in the non-display area NDA, the second electrode CAT located on the first bank BK1 and the second bank BK2 of the non-display area NDA may not be disconnected. Accordingly, even though the bank layer SPR is positioned in the non-display area NDA, the disconnection of the second electrode CAT in the non-display area NDA may be prevented. Accordingly, the second electrode CAT and the third power connection electrode 903 may be normally connected in the power connection area CCA of the non-display area NDA. In some embodiments, since the second electrode CAT is supported by the light emitting stack layer IL in the display area DAA, the second electrode CAT located on the second bank BK2 of the display area DAA may not be disconnected.

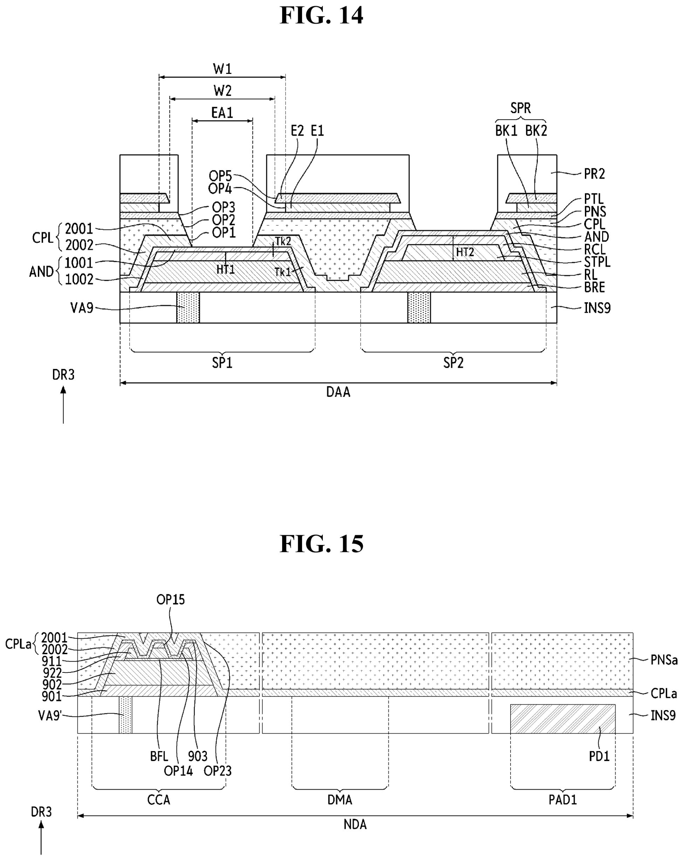

FIGS. 9, 10, 11, 12, 13, 14, 15, 16, 17, 18, 19, and 20 are process cross-sectional views for explaining a method for fabricating the display device 10 according to at least one example embodiment. For example, FIGS. 9 to 14 are process cross-sectional views for explaining the method for fabricating the display device 10 in the display area DAA of FIG. 7 described above, and FIGS. 15 to 20 are process cross-sectional views for explaining the method for fabricating the display device 10 in the non-display area NDA of FIG. 8 described above.

First, as illustrated in FIGS. 9 and 15, the first pad PD1 may be formed in the non-display area NDA (for example, the first pad area PAD1 of the non-display area NDA) of the semiconductor substrate SSUB, and the ninth insulating layer INS9 may be formed on the entire surface of the semiconductor substrate SSUB including the first pad PD1. Next, the ninth via electrodes VA9 and VA9' may be formed in the ninth insulating layer INS9. Thereafter, the barrier electrode BRE may be formed on the ninth insulating layer INS9 so as to be in contact with the ninth via electrode VA9 of the display area DAA (for example, the first sub-pixel area SP1 and the second sub-pixel area SP2 of the display area DAA) of the semiconductor substrate SSUB, and, also, the first power connection electrode 901 may be formed on the ninth insulating layer INS9 so as to be in contact with the ninth via electrode VA9' of the non-display area NDA (for example, the power connection area CCA of the non-display area NDA) of the semiconductor substrate SSUB.

Thereafter, the reflective electrode RL may be formed on the barrier electrode BRE, and the second power connection electrode 902 may be formed on the first power connection electrode 901. Next, the buffer layer BFL may be formed on the second power connection electrode 902. Next, the step layer STPL may be formed on the reflective electrode RL of the second sub-pixel area SP2, and the first auxiliary layer 911 may be formed on the buffer layer BFL of the power connection area CCA.

Thereafter, the resonance control layer RCL may be formed on the reflective electrode RL of the first sub-pixel area SP1 as well as on the step layer STPL and the reflective electrode RL of the second sub-pixel area SP2, and the second auxiliary layer 922 may be formed on the first auxiliary layer 911 and the second power connection electrode 902 of the power connection area CCA. Thereafter, the fourteenth opening OP14 and the fifteenth opening OP15 penetrating the first auxiliary layer 911 and the second auxiliary layer 922 of the power connection area CCA, respectively, may be formed, so that the buffer layer BFL may be exposed. Next, the first electrode AND may be formed on the resonance control layer RCL of the display area DAA (for example, the first sub-pixel area SP1 and the second sub-pixel area SP2 of the display area DAA), and the third power connection electrode 903 may be formed on the second auxiliary layer 922 of the non-display area NDA (for example, the power connection area CCA of the non-display area NDA). In these cases, the third power connection electrode 903 may be connected to the buffer layer BFL through the fourteenth opening OP14 and the fifteenth opening OP15. Subsequently, a preliminary capping layer CPLa may be formed on the first electrode AND and the third power connection electrode 903. Next, a preliminary planarization layer PNSa may be formed on the preliminary capping layer CPLa. The preliminary capping layer CPLa may include an upper capping portion 2001 and a side capping portion 2002. The upper capping portion 2001 of the preliminary capping layer CPLa may overlap the entire upper electrode portion 1001 of the first electrode AND and the entire third power connection electrode 903.

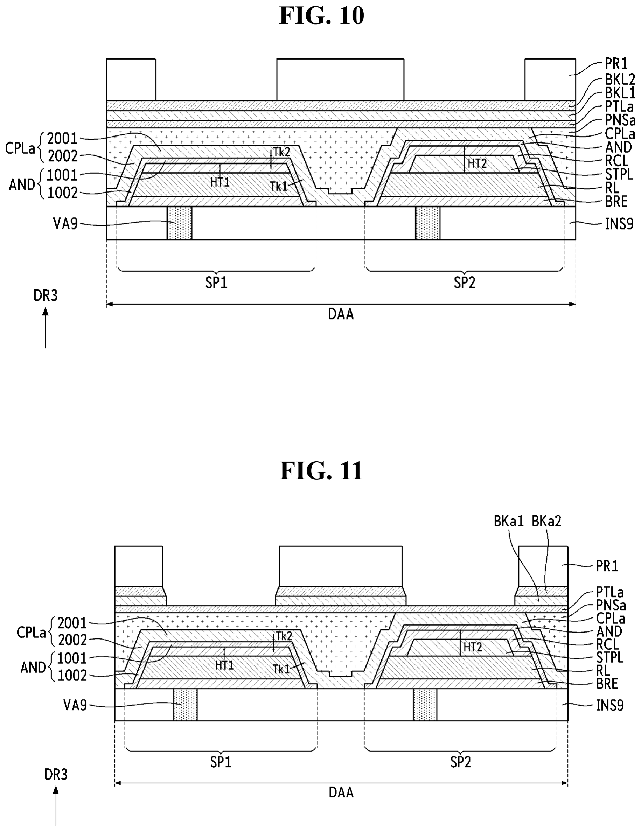

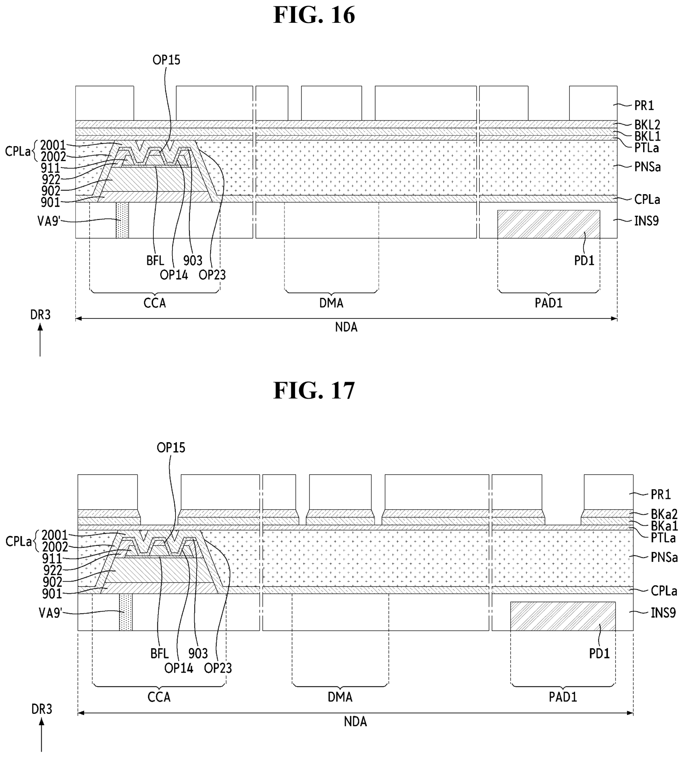

Subsequently, as illustrated in FIGS. 10 and 16, a preliminary protective layer PTLa may be formed on the preliminary planarization layer PNSa and the exposed preliminary capping layer CPLa; a first bank layer BKL1 may be formed on the preliminary protective layer PTLa; a second bank layer BKL2 may be formed on the first bank layer BKL1; and a first photoresist pattern PR1 may be formed on the second bank layer BKL2. For example, the first photoresist pattern PR1 may be formed on the second bank layer BKL2 so as not to overlap each of the emission areas EA1, EA2, and EA3, a portion of the power connection area CCA, a portion of the dam area DMA, and a portion of the first pad area PAD1.

Next, as illustrated in FIGS. 11 and 17, the first bank layer BKL1 and the second bank layer BKL2 may be patterned using the first photoresist pattern PR1 as a mask. For example, the first bank layer BKL1 and the second bank layer BKL2 may be etched and patterned through an etching process using the first photoresist pattern PR1 as a mask, thereby forming a first preliminary bank BKa1 and a second preliminary bank BKa2. In addition, as the first bank layer BKL1 and the second bank layer BKL2 are patterned using the first photoresist pattern PR1 as a mask as described above, the preliminary protective layer PTLa may be exposed. In these cases, the first bank layer BKL1 and the second bank layer BKL2 may be etched through physical etching. Accordingly, the first bank layer BKL1 and the second bank layer BKL2 may be etched into the same and/or substantially similar pattern.

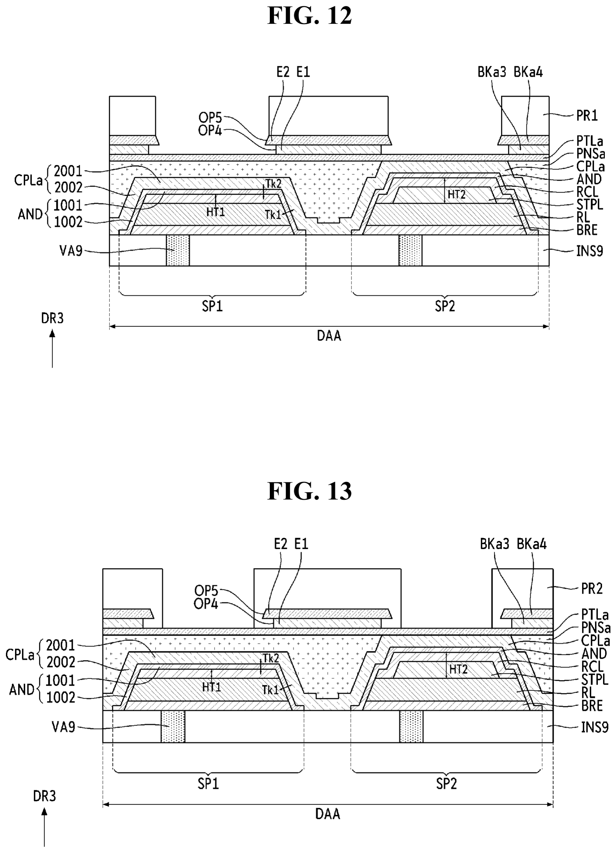

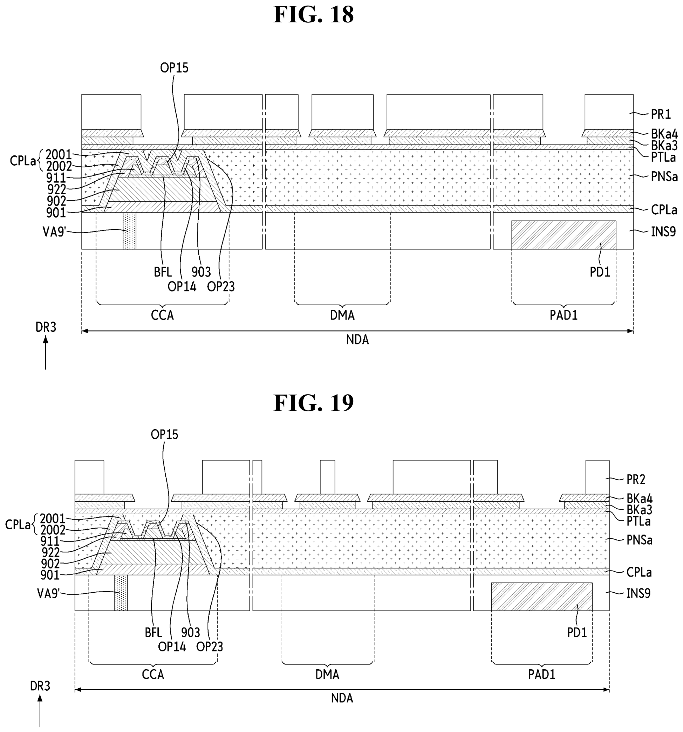

Next, as shown in FIGS. 12 and 18, the first preliminary bank BKa1 and the second preliminary bank BKa2 may be etched and patterned through an etching process using the first photoresist pattern PR1 as a mask, thereby forming a third preliminary bank BKa3 and a fourth preliminary bank BKa4. In these cases, the first preliminary bank BKa1 and the second preliminary bank BKa2 may be etched through chemical etching. Accordingly, the first preliminary bank BKa1 and the second preliminary bank BKa2 may be etched at different etching rates. By way of example, the etching rate of the material (e.g., silicon nitride) used as the first preliminary bank BKa1 (e.g., the first bank layer BKL1) may be greater than the etching rate of the material (e.g., silicon oxide) used as the second preliminary bank BKa2 (e.g., the second bank layer BKL2). Therefore, during the chemical etching process, the first preliminary bank BKa1 may be removed more than the second preliminary bank BKa2. Accordingly, the edge of the fourth preliminary bank BKa4 formed by this chemical etching process may extend beyond the edge of the third preliminary bank BKa3 toward the preliminary protective layer PTLa (e.g., the exposed preliminary protective layer PTLa). In other words, the edge of the fourth preliminary bank BKa4 may be further extended in the first direction DR1 and the second direction DR2 beyond the edge of the third preliminary bank BKa3.

Thereafter, after the first photoresist pattern PR1 is removed, a second photoresist pattern PR2 may be formed on the preliminary protective layer PTLa and the fourth preliminary bank BKa4, as illustrated in FIGS. 13 and 19. In these cases, the second photoresist pattern PR2 may be formed to cover the entire third preliminary bank BKa3 and the entire fourth preliminary bank BKa4 in the display area DAA (e.g., the display area DAA including the first sub-pixel area SP1 and the second sub-pixel area SP2). On the other hand, the second photoresist pattern PR2 may be formed on the fourth preliminary bank BKa4 so as not to overlap the edge of the third preliminary bank BKa3 in the non-display area NDA (e.g., the non-display area NDA including the power connection area CCA, the dam area DMA, and the first pad area PAD1). Here, the second photoresist pattern PR2 may have a width smaller than the width of the third preliminary bank BKa3 in the non-display area NDA. Accordingly, the edge of the third preliminary bank BKa3 and the edge of the fourth preliminary bank BKa4 in the non-display area NDA may be exposed to the outside without being covered by the second photoresist pattern PR2.

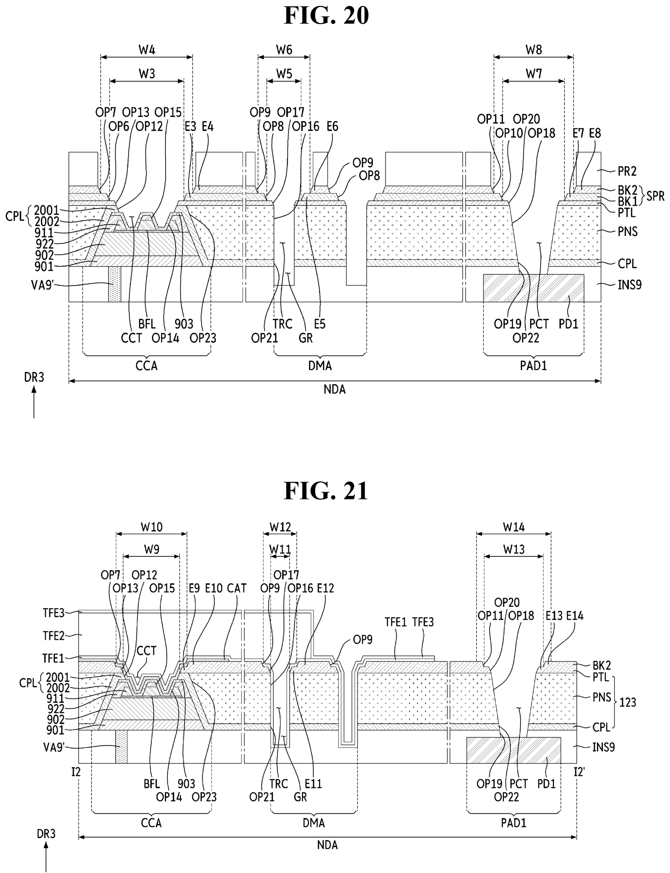

Next, as illustrated in FIGS. 14 and 20, the ninth insulating layer INS9, the preliminary capping layer CPLa, the preliminary planarization layer PNSa, the preliminary protective layer PTLa, the third preliminary bank BKa3, and the fourth preliminary bank BKa4 are etched and patterned through an etching process using the second photoresist pattern PR2 as a mask, thereby forming the groove GR, the capping layer CPL, the planarization layer PNS, the protective layer PTL, the first bank BK1, and the second bank BK2. For example, the ninth insulating layer INS9 having the groove GR, the capping layer CPL having a plurality of openings (the first opening OP1, the twelfth opening OP12, the twenty-first opening OP21, and the twenty-second opening OP22), the planarization layer PNS having a plurality of openings (the second opening OP2, the sixteenth opening OP16, and the eighteenth opening OP18), the protective layer PTL having a plurality of openings (the third opening OP3, the thirteenth opening OP13, the seventeenth opening OP17, and the twentieth opening OP20), the first bank BK1 having a plurality of openings (the fourth opening OP4, the sixth opening OP6, the eighth opening OP8, and the tenth opening OP10), and the second bank BK2 having a plurality of openings (the fifth opening OP5, the seventh opening OP7, the ninth opening OP9, and the eleventh opening OP11) may be formed. Accordingly, the first electrode AND may be exposed in each sub-pixel area, the third power connection electrode 903 may be exposed in the power connection area CCA, the ninth insulating layer INS9 within the trench TRC may be exposed in the dam area DMA, and the first pad PD1 may be exposed in the first pad area PAD1. In these cases, the ninth insulating layer INS9, the preliminary capping layer CPLa, the preliminary planarization layer PNSa, the preliminary protective layer PTLa, the third preliminary bank BKa3, and the fourth preliminary bank BKa4 may be etched through mechanical etching. Accordingly, the edge of the second bank BK2 in the display area DAA may be kept extended beyond the edge of the first bank BK1 toward the first opening OP1 of the capping layer CPL, while the edge of the first bank BK1 in the non-display area NDA may extend beyond the edge of the second bank BK2 toward the corresponding opening of the non-display area NDA. For example, the edge of the first bank BK1 of the power connection area CCA may extend beyond the edge of the second bank BK2 toward the thirteenth opening OP13 of the protective layer PTL; the edge of the first bank BK1 of the dam area DMA may extend beyond the edge of the second bank BK2 toward the seventeenth opening OP17 of the protective layer PTL; and the edge of the first bank BK1 of the first pad area PAD1 may extend beyond the edge of the second bank BK2 toward the twentieth opening OP20 of the protective layer PTL. In some example embodiments, since the etching depth in the mechanical etching process shown in FIGS. 14 and 20 is greater than the etching depth in FIG. 11, the mechanical etching process time in FIGS. 14 and 20 may be longer than that in FIG. 11. Accordingly, in the mechanical etching process in FIGS. 14 and 20, the fourth preliminary bank BKa4 closer to the second photoresist pattern PR2 may be etched more than the third preliminary bank BKa3. Accordingly, the first bank BK1 and the second bank BK2 may have a step-shaped cross-section.

Next, as shown in FIGS. 7 and 8, the light emitting stack layer IL may be formed on the first electrodes AND, the capping layer CPL, and the bank layers SPR; the second electrode CAT may be formed on the light emitting stack layer IL; and the encapsulation layer TFE may be formed on the second electrode CAT. In these cases, the light emitting stack layer IL may be separated for each of the sub-pixel areas SP1, SP2, and SP3 by the bank layer SPR. In other words, since the width of the second bank BK2 of the display area (e.g., the display area DAA including the sub-pixel areas SP1, SP2, and SP3) is larger than the width of the first bank BK1, the light emitting stack layer IL located on the second bank BK2 of the display area DAA may be disconnected by the bank layer SPR.

FIG. 21 is a cross-sectional view illustrating another example of the display panel 100 taken along line I1-I1' of FIG. 3.

The display device 10 of FIG. 21 is different from the above-described display device 10 of FIG. 8 in the structure of the bank layer SPR in the non-display area NDA, and the following description will mainly focus on this difference.

As illustrated in FIG. 21, the bank layer SPR may be located on the intermediate layer 123. The bank layer SPR may have a ninth opening portion overlapping the third power connection electrode 903 and the second opening of the intermediate layer 123 in the power connection area CCA of the non-display area NDA; a tenth opening portion overlapping the third opening portion of the intermediate layer 123 in the dam area DMA of the non-display area NDA; and an eleventh opening portion overlapping the first pad PD1 and the fourth opening portion of the intermediate layer 123 in the first pad area PAD1 of the non-display area NDA. Here, the ninth opening portion of the bank layer SPR may include the seventh opening OP7 overlapping the third power connection electrode 903 and the second opening portion of the intermediate layer 123; the tenth opening portion of the bank layer SPR may include the ninth opening OP9 overlapping the third opening portion of the intermediate layer 123; and the eleventh opening portion of the bank layer SPR may include the eleventh opening OP11 overlapping the first pad PD1 and the fourth opening portion of the intermediate layer 123. This bank layer SPR may include the first bank BK1 and the second bank BK2 as stated above.

As illustrated in FIG. 21, the bank layer SPR may not include the first bank BK1 in the non-display area NDA (e.g., the power connection area CCA, the dam area DMA, and the first pad area PAD1). For example, the bank layer SPR of FIG. 21 may include the first bank BK1 and the second bank BK2 in the display area DAA (e.g., the first to third sub-pixel areas SP1, SP2, and SP3) (see FIG. 7), while including the second bank BK2 in the non-display area NDA. In other words, among the first bank BK1 and the second bank BK2 of the bank layer SPR, the first bank BK1 may be located in the display area DAA, while it is not located in the non-display area NDA. In some example embodiments, the second bank BK2 of the bank layer SPR may be located together in both the display area DAA and the non-display area NDA.

In the non-display area NDA, the second bank BK2 may be located on the protective layer PTL. For example, in the power connection area CCA, the dam area DMA, and the first pad area PAD1, the second bank BK2 may be located on the protective layer PTL. In the non-display area NDA, the second bank BK2 may be in contact (or direct contact) with the protective layer PTL. When the second bank BK2 and the protective layer PTL include the same material, the second bank BK2 and the protective layer PTL in the non-display area NDA may be formed integrally without an interface between the second bank BK2 and the protective layer PTL.

In a direction parallel to the semiconductor substrate SSUB, an edge E9 of the protective layer PTL of the power connection area CCA may extend beyond an edge E10 of the second bank BK2 toward the thirteenth opening OP13 of the protective layer PTL. Accordingly, a width W9 of the thirteenth opening OP13 included in the protective layer PTL of the power connection area CCA may be smaller than a width W10 of the seventh opening OP7 included in the second bank BK2. Thereby, the bank layer SPR may be referred to as having a step-shaped structure and/or a non-undercut structure in the power connection area CAA above the thirteenth opening OP13. In a plan view, the thirteenth opening OP13 of the protective layer PTL of the power connection area CCA may be surrounded by the seventh opening OP7 of the second bank BK2.

In a direction parallel to the semiconductor substrate SSUB, an edge E11 of the protective layer PTL of the dam area DMA may extend beyond an edge E12 of the second bank BK2 toward the seventeenth opening OP17 of the protective layer PTL. Accordingly, a width W11 of the seventeenth opening OP17 included in the protective layer PTL of the dam area DMA may be smaller than a width W12 of the ninth opening OP9 included in the second bank BK2. Thereby, the bank layer SPR may be referred to as having a step-shaped structure and/or a non-undercut structure in the dam area DMA above the seventeenth opening OP17. In a plan view, the seventeenth opening OP17 of the protective layer PTL of the dam area DMA may be surrounded by the ninth opening OP9 of the second bank BK2.

In a direction parallel to the semiconductor substrate SSUB, an edge E13 of the protective layer PTL of the first pad area PAD1 may extend beyond an edge E14 of the second bank BK2 toward the twentieth opening OP20 of the protective layer PTL. Accordingly, a width W13 of the twentieth opening OP20 included in the protective layer PTL of the first pad area PAD1 may be smaller than a width W14 of the eleventh opening OP11 included in the second bank BK2. Thereby, the bank layer SPR may be referred to as having a step-shaped structure and/or a non-undercut structure in the first pad area PAD1 above the twentieth opening OP20. In a plan view, the twentieth opening OP20 of the protective layer PTL of the first pad area PAD1 may be surrounded by the eleventh opening OP11 of the second bank BK2.

The second electrode CAT may be connected to the third power connection electrode 903 through the power contact hole CCT. According to at least one example embodiment, since the width of the second bank BK2 of the non-display area NDA is smaller than the width of the protective layer PTL, the second electrode CAT located on the second bank BK2 and the protective layer PTL of the non-display area NDA may not be disconnected. Accordingly, even though the bank layer SPR is positioned in the non-display area NDA, disconnection of the second electrode CAT in the non-display area NDA may be prevented. Accordingly, the second electrode CAT and the third power connection electrode 903 may be normally connected in the power connection area CCA of the non-display area NDA. In some embodiments, since the second electrode CAT in the display area DAA is supported by the light emitting stack layer IL, the second electrode CAT located on the second bank BK2 of the display area DAA may not be disconnected.

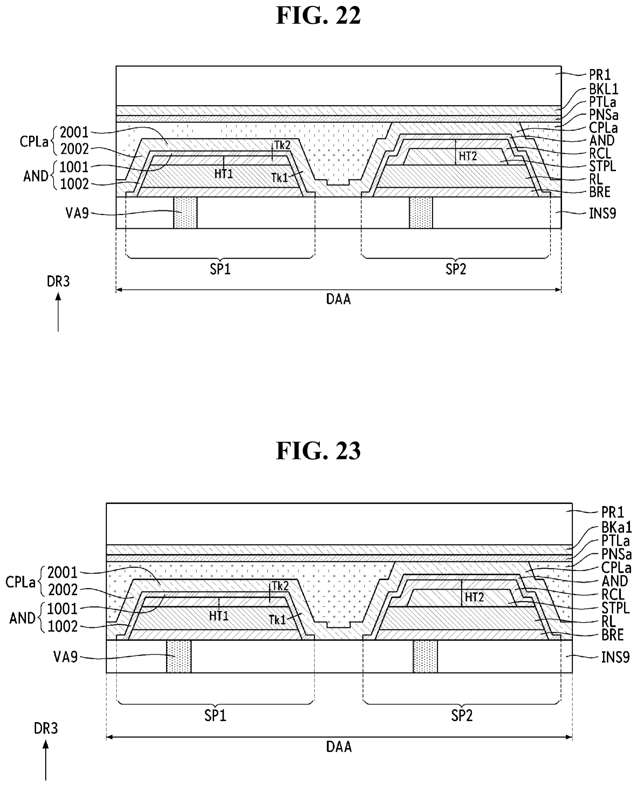

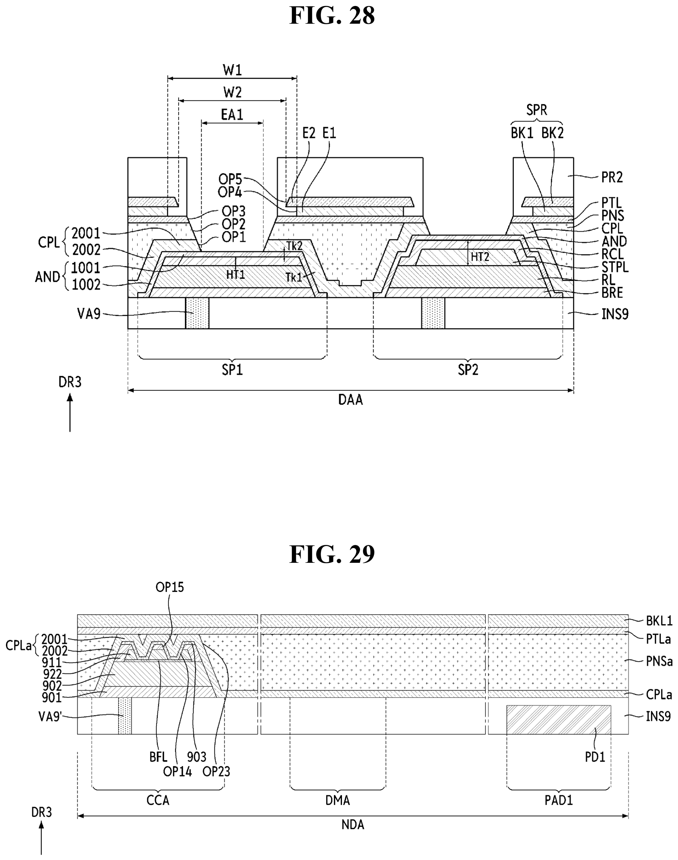

FIGS. 22, 23, 24, 25, 26, 27, 28, 29, 30, 31, 32, and 33 are process cross-sectional views for explaining a method for fabricating the display device 10 according to at least one example embodiment. For example, FIGS. 22 to 28 are process cross-sectional views for explaining the method for fabricating the display device 10 in the display area DAA of FIG. 7 described above, and FIGS. 29 to 33 are process cross-sectional views for explaining the method for fabricating the display device 10 in the non-display area NDA of FIG. 21 described above.

First, as illustrated in FIGS. 9 and 15 described above, the ninth insulating layer INS9, the ninth via electrodes VA9 and VA9', the first pad PD1, the barrier electrode BRE, the first power connection electrode 901, the reflective electrode RL, the second power connection electrode 902, the buffer layer BFL, the step layer STPL, the first auxiliary layer 911, the resonance control layer RCL, the second auxiliary layer 922, the third power connection electrode 903, the preliminary capping layer CPLa, and the preliminary planarization layer PNSa may be formed on the semiconductor substrate SSUB. Refer to FIGS. 9 and 15 for the description of the fabricating method for these components.

Thereafter, as illustrated in FIGS. 22 and 29, the preliminary protective layer PTLa may be formed on the preliminary planarization layer PNSa and the exposed preliminary capping layer CPLa; the first bank layer BKL1 may be formed on the preliminary protective layer PTLa; and the first photoresist pattern PR1 may be formed on the first bank layer BKL1. For example, the first photoresist pattern PR1 may be formed on the first bank layer BKL1 so as not to overlap the power connection area CCA, the dam area DMA, and the first pad area PAD1 of the non-display area NDA. Accordingly, the first photoresist pattern PR1 is not formed on the first bank layer BKL1 on the power connection area CCA, the dam area DMA, and the first pad area PAD1. In other words, the first bank layer BKL1 on the power connection area CCA, the dam area DMA, and the first pad area PAD1 may be exposed to the outside without being covered by the first photoresist pattern PR1.

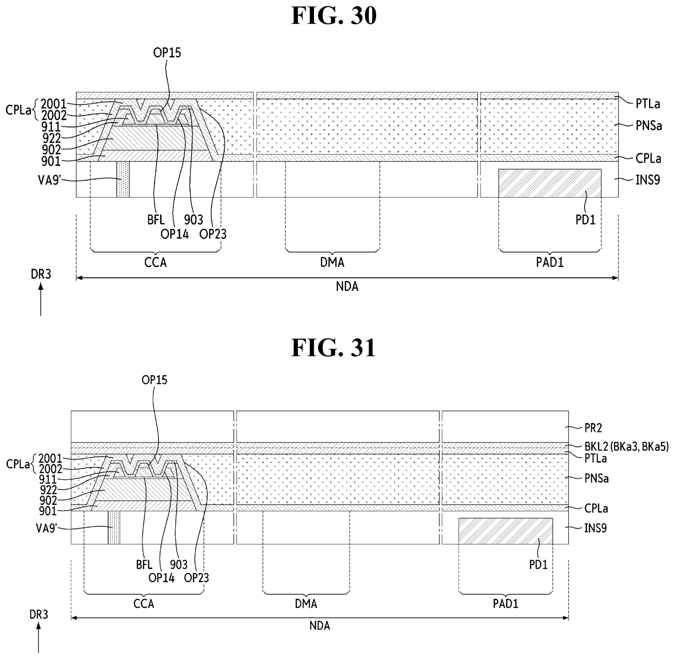

Next, as illustrated in FIGS. 23 and 30, the first bank layer BKL1 may be patterned using the first photoresist pattern PR1 as a mask. By way of example, the first bank layer BKL1 may be etched and patterned through an etching process using the first photoresist pattern PR1 as a mask, thereby forming the first preliminary bank BKa1 on the preliminary planarization layer PNSa of the display area DAA. In addition, as the first bank layer BKL1 is patterned using the first photoresist pattern PR1 as a mask as described above, the preliminary protective layer PTLa may be exposed in the non-display area NDA. In other words, as the first bank layer BKL1 is removed in the non-display area NDA, the preliminary protective layer PTLa may be exposed in the non-display area NDA. In these cases, the first bank layer BKL1 may be etched through physical etching.

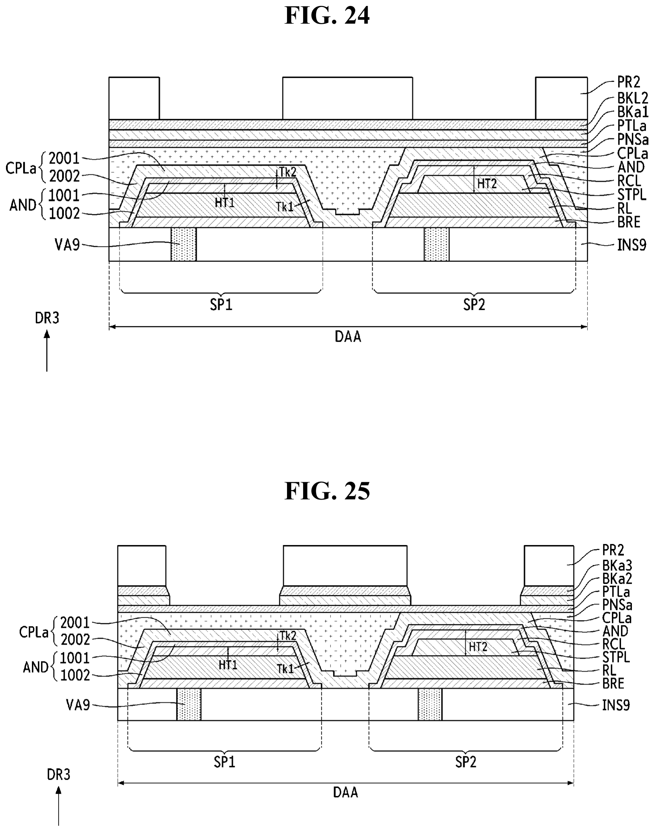

Subsequently, after the first photoresist pattern PR1 is removed, the second bank layer BKL2 may be formed on the first preliminary bank BKa1 of the display area DAA and the preliminary protective layer PTLa of the non-display area NDA, and then, the second photoresist pattern PR2 may be formed on the second bank layer BKL2, as shown in FIGS. 24 and 31. For example, the second photoresist pattern PR2 may be formed on the second bank layer BKL2 so as not to overlap each of the emission areas EA1, EA2 and EA3. In addition, the second photoresist pattern PR2 may be formed on the second bank layer BKL2 so as to cover the power connection area CCA, the dam area DMA, and the first pad area PAD1 of the non-display area NDA.

Next, as illustrated in FIGS. 25 and 31, the first preliminary bank BKa1 and the second bank layer BKL2 of the display area DAA may be patterned using the second photoresist pattern PR2 as a mask. For example, the first preliminary bank BKa1 and the second bank layer BKL2 of the display area DAA may be etched and patterned through an etching process using the second photoresist pattern PR2 as a mask, thereby forming the second preliminary bank BKa2 and the third preliminary bank BKa3 in the display area DAA. In addition, as described above, as the first preliminary bank BKa1 and the second bank layer BKL2 of the display area DAA is patterned using the second photoresist pattern PR2 as a mask, the preliminary protective layer PTLa may be exposed in the display area DAA. In these cases, the first preliminary bank BKa1 and the second bank layer BKL2 may be etched through physical etching. Accordingly, the first preliminary bank BKa1 and the second bank layer BKL2 may be etched into the same and/or substantially similar pattern.

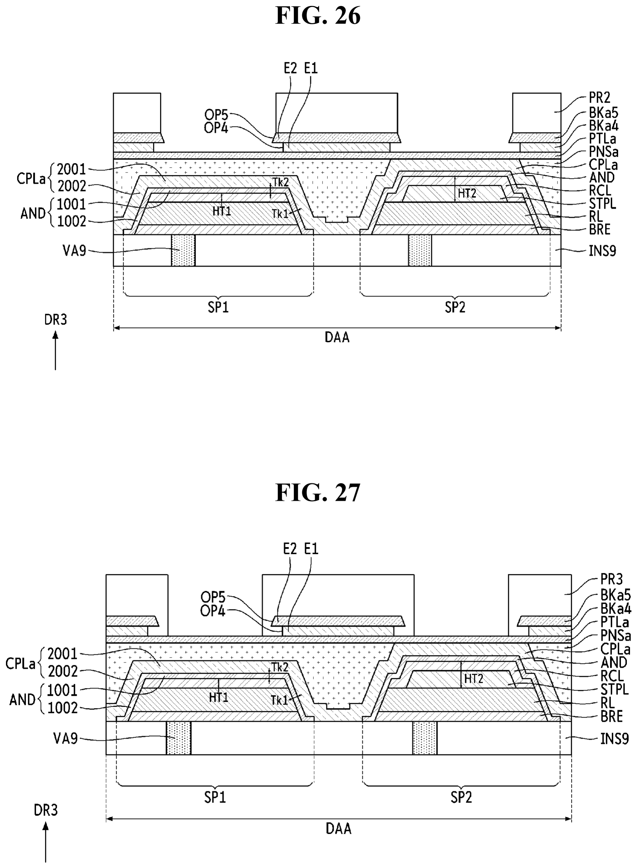

Next, as shown in FIGS. 26 and 31, the second preliminary bank BKa2 and the third preliminary bank BKa3 of the display area DAA are etched and patterned through an etching process using the second photoresist pattern PR2 as a mask, thereby forming the fourth preliminary bank BKa4 and a fifth preliminary bank BKa5 in the display area DAA. In these cases, the second preliminary bank BKa2 and the third preliminary bank BKa3 may be etched through chemical etching. Accordingly, the second preliminary bank BKa2 and the third preliminary bank BKa3 may be etched at different etching rates. For example, the etching rate of the material (e.g., silicon nitride) used as the second preliminary bank BKa2 (e.g., the first bank layer BKL1) may be greater than the etching rate of the material (e.g., silicon oxide) used as the third preliminary bank BKa3 (e.g., the second bank layer BKL2). Therefore, during the chemical etching process, the second preliminary bank BKa2 may be removed more than the third preliminary bank BKa3. Accordingly, the edge of the fifth preliminary bank BKa5 formed by this chemical etching process may be further extended beyond the edge of the fourth preliminary bank BKa4 toward the preliminary protective layer PTLa (e.g., the exposed preliminary protective layer PTLa). In other words, the edge of the fifth preliminary bank BKa5 may be further extended in the first direction DR1 and the second direction DR2 beyond the edge of the fourth preliminary bank BKa4.

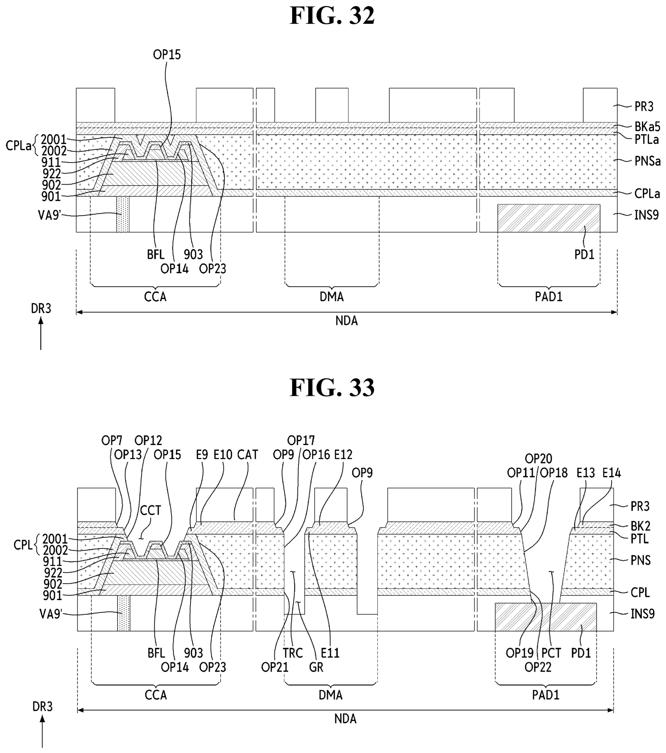

Thereafter, after the second photoresist pattern PR2 is removed, a third photoresist pattern PR3 may be formed on the preliminary protective layer PTLa and the fifth preliminary bank BKa5, as illustrated in FIGS. 27 and 32. In these cases, the third photoresist pattern PR3 may be formed to cover the entire fourth preliminary bank BKa4 and the entire fifth preliminary bank BKa5 in the display area DAA (e.g., the display area DAA including the first sub-pixel area SP1 and the second sub-pixel area SP2). On the other hand, the third photoresist pattern PR3 may be located on the fifth preliminary bank BKa5 so as not to overlap the power connection area CCA, the dam area DMA, and the first pad area PAD1 in the non-display area NDA.

Next, as illustrated in FIGS. 28 and 33, the ninth insulating layer INS9, the preliminary capping layer CPLa, the preliminary planarization layer PNSa, the preliminary protective layer PTLa, the fourth preliminary bank BKa4, and the fifth preliminary bank BKa5 are etched and patterned through an etching process using the third photoresist pattern PR3 as a mask, thereby forming the groove GR, the capping layer CPL, the planarization layer PNS, the protective layer PTL, the first bank BK1, and the second bank BK2. For example, the ninth insulating layer INS9 having the groove GR, the capping layer CPL having a plurality of openings (the first opening OP1, the twelfth opening OP12, the twenty-first opening OP21, and the twenty-second opening OP22), the planarization layer PNS having a plurality of openings (the second opening OP2, the sixteenth opening OP16, and the eighteenth opening OP18), the protective layer PTL having a plurality of openings (the third opening OP3, the thirteenth opening OP13, the seventeenth opening OP17, and the twentieth opening OP20), the first bank BK1 having the fourth opening OP4, and the second bank BK2 having a plurality of openings (the fifth opening OP5, the seventh opening OP7, the ninth opening OP9, and the eleventh opening OP11) may be formed. Accordingly, the first electrode AND may be exposed in each sub-pixel area, the third power connection electrode 903 may be exposed in the power connection area CCA, the ninth insulating layer INS9 within the trench TRC may be exposed in the dam area DMA, and the first pad PD1 may be exposed in the first pad area PAD1. In these cases, the ninth insulating layer INS9, the preliminary capping layer CPLa, the preliminary planarization layer PNSa, the preliminary protective layer PTLa, the fourth preliminary bank BKa4, and the fifth preliminary bank BKa5 may be etched through mechanical etching. Accordingly, the edge of the second bank BK2 in the display area DAA may be kept extended beyond the edge of the first bank BK1 toward the first opening OP1 of the capping layer CPL, and the edge of the protective layer PTL in the non-display area NDA may extend beyond the edge of the second bank BK2 toward the corresponding opening of the non-display area NDA. For example, the edge of the protective layer PTL of the power connection area CCA may extend beyond the edge of the second bank BK2 toward the thirteenth opening OP13 of the protective layer PTL; the edge of the protective layer PTL of the dam area DMA may extend beyond the edge of the second bank BK2 toward the seventeenth opening OP17 of the protective layer PTL; and the edge of the protective layer PTL of the first pad area PAD1 may extend beyond the edge of the second bank BK2 toward the twentieth opening OP20 of the protective layer PTL. In some example embodiments, since the etching depth in the mechanical etching process in FIGS. 28 and 33 is greater than the etching depth in FIG. 25, the mechanical etching process time in FIGS. 28 and 33 may be longer than that in FIG. 25. Accordingly, in the mechanical etching process in FIGS. 28 and 33, the fifth preliminary bank BKa5 closer to the third photoresist pattern PR3 may be etched more than the preliminary protective layer PTLa. Accordingly, the second bank BK2 and the protective layer PTL may have a step-shaped cross-section.

Next, as illustrated in FIGS. 7 and 8, the light emitting stack layer IL may be formed on the first electrodes AND, the capping layer CPL, and the bank layer SPR, the second electrode CAT may be formed on the light emitting stack layer IL, and the encapsulation layer TFE may be formed on the second electrode CAT. In these cases, the light emitting stack layer IL may be separated for each of the sub-pixel areas SP1, SP2, and SP3 by the bank layer SPR.

The display device 10 according to the example embodiments may be applied to various electronic devices. An electronic device according to at least one example embodiment may include the above-described display device 10, and may further include, in addition to the display device 10, a module or device having other additional functions.

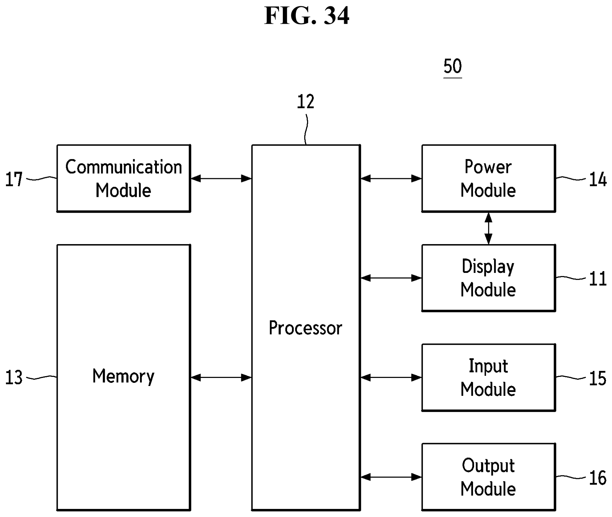

FIG. 34 is a block diagram of an electronic device according to at least one example embodiment. Referring to FIG. 34, an electronic device 50 according to at least one example embodiment may include a display module 11, a processor 12, a memory 13, and a power module 14. The electronic device 50 may further include an input module 15, a non-visual output module 16, and/or a communication module 17.

The electronic device 50 may output various information in the form of images through the display module 11. When the processor 12 executes an application stored in the memory 13, image information provided by the application may be provided to a user through the display module 11. The power module 14 may include a power supply module, such as a power adapter or a battery device, and a power conversion module that converts the power supplied by the power supply module to generate the power required for the operation of the electronic device 50. The input module 15 may provide input information to the processor 12 and/or the display module 11. The non-visual output module 16 may serve to receive information other than images, such as sound, haptics, luminescence, etc., sent from the processor 12, and provide it to the user. The communication module 17 is a module responsible for the transmission and reception of information between the electronic device 50 and an external device, and may include a receiver and a transmitter.

At least one of the respective components of the electronic device 50 described above may be included in the display device according to the example embodiments described above. Further, some of the individual modules functionally included in one module may be included in the display device and some others may be provided separately from the display device. For example, the display device may include the display module 11, whereas the processor 12, the memory 13 and the power module 14 may be provided in the form of other devices in the electronic device 50, other than the display device.

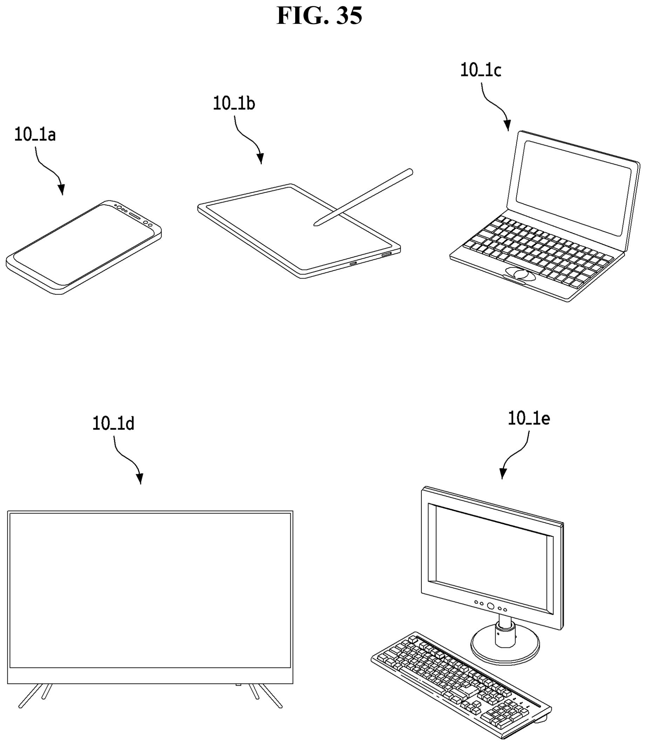

FIGS. 35, 36 and 37 are schematic diagrams illustrating electronic devices according to various embodiments. FIGS. 35 to 37 illustrate examples of various electronic devices to which the display device 10 according to the above-described embodiments are applied.

FIG. 35 shows a smartphone 10_1a, a tablet PC 10_1b, a laptop 10_1c, a TV 10_1d, and a desk monitor 10_1e as examples of electronic devices.

The smartphone 10_1a may include a communication module and an input module such as a touch sensor, etc., in addition to the display module 11. The smartphone 10_1a may process the information received through the communication module or input module and display the processed information through the display module of the display device.

Each of the tablet PC 10_1b, the laptop 10_1c, the TV 10_1d, and the desk monitor 10_1e may include a display and an input module, similarly to the smartphone 10_1a, and may further include a communication module in some cases.

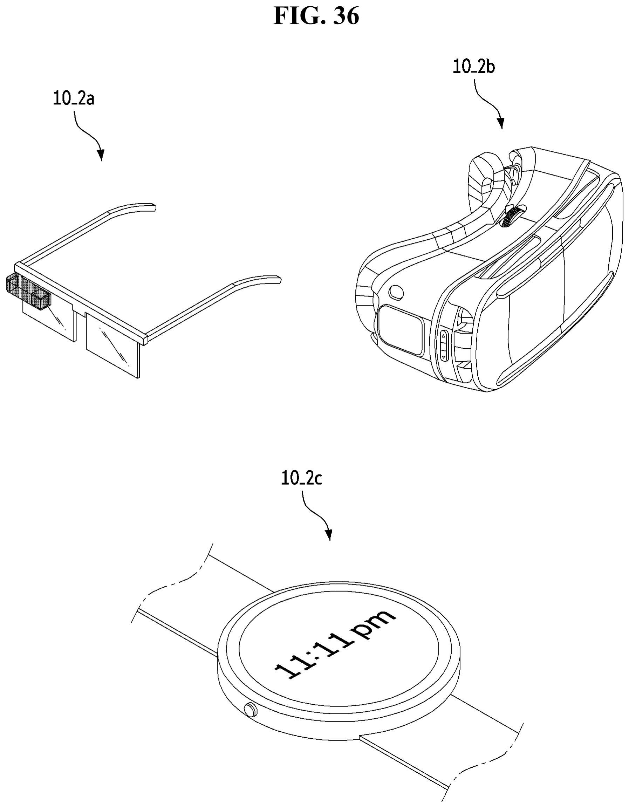

FIG. 36 illustrates a case in which an electronic device including a display module is applied to a wearable electronic device. The wearable electronic device may be smart glasses 10_2a, a head mounted display 10_2b, a smart watch 10_2c, and the like.

The smart glasses 10_2a and the head mounted display 10_2b may include a display module that outputs a display image and a reflector that reflects the outputted display image to provide it to the user's eyes, thereby providing the user with a virtual reality or augmented reality screen.

The smart watch 10_2c may include a biometric sensor as an input device, and may provide biometric information recognized through the biometric sensor to the user through a display module.

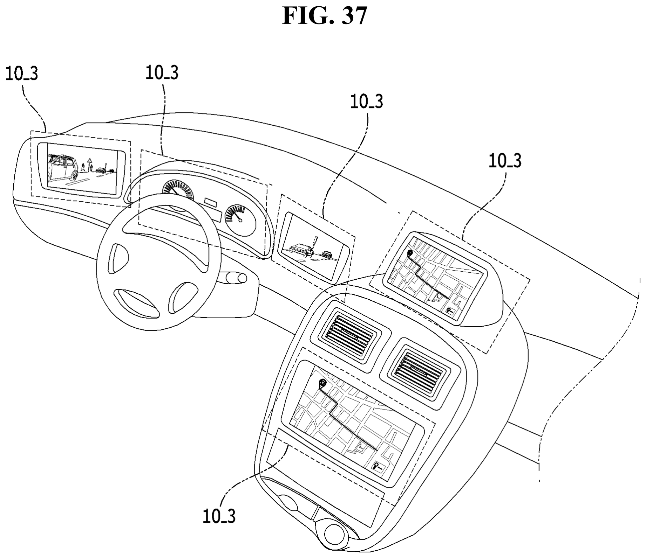

FIG. 37 illustrates a case in which an electronic device including a display module is applied to a vehicle. For example, an electronic device 10_3 may be applied to a dashboard or center fascia of a vehicle, or to a center information display (CID) placed in the dashboard of the vehicle or a room mirror display that replaces a side mirror.

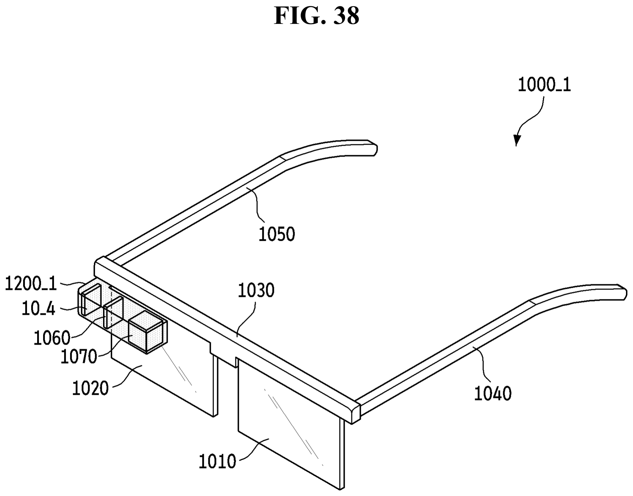

FIG. 38 is a perspective view illustrating a head mounted display according to at least one example embodiment. For example, FIG. 38 may be a detailed configuration diagram of the smart glasses 10_2a of FIG. 36.

Referring to FIG. 38, a head mounted display 1000_1 according to at least one example embodiment may be an eyeglasses-type display device in which a display device housing 1200_1 is implemented in a lightweight and compact manner. The head mounted display 1000_1 according to at least one example embodiment may include a display device 10_4, a left eye lens 1010, a right eye lens 1020, a support frame 1030, temples 1040 and 1050, an optical member 1060 (e.g., a lens), an optical path changing member 1070 (e.g., a mirror), and the display device housing 1200_1.

The display device housing 1200_1 may include the display device 10_4, the optical member 1060, and the optical path changing member 1070. The optical member 1060, and the optical path changing member 1070 may adjust the path of light emitted from the display device 10_4. For example, the image displayed on the display device 10_4 may be magnified by the optical member 1060, and may be provided to the user's right eye through the right eye lens 1020 after the optical path is changed by the optical path changing member 1070. As a result, the user may view an augmented reality image, through the right eye, in which a virtual image displayed on the display device 10_4 and a real image seen through the right eye lens 1020 are combined.

FIG. 38 illustrates that the display device housing 1200_1 is located at the right end of the support frame 1030, but the example embodiments of the present disclosure are not limited thereto. For example, the display device housing 1200_1 may be located at the left end of the support frame 1030, and in these cases, the image of the display device 10_3 may be provided to the user's left eye. Alternatively, the display device housing 1200_1 may be located at both the left and right ends of the support frame 1030, and in these cases, the user may view the image displayed on the display device 10_3 through both the left and right eyes.

In concluding the detailed description, those skilled in the art will appreciate that many variations and modifications can be made to the preferred embodiments without substantially departing from the principles of the present invention. Therefore, the disclosed preferred embodiments of the invention are used in a generic and descriptive sense only and not for purposes of limitation.

## Claims

1. A display device (10) comprising:
a substrate (SSUB) comprising a display area (DAA) and a non-display area (NDA);
a first electrode (AND) in a sub-pixel area (SP1, SP2, SP3) of the display area (DAA);
a power connection electrode (903) in a power connection area (CCA) of the non-display area (NDA);
an intermediate layer (123) on the first electrode (AND) and on the power connection electrode (903), the intermediate layer (123) defining a first opening portion (OP1, OP2, OP3) and a second opening portion (OP12, OP23, OP13), the first opening portion (OP1, OP2, OP3) overlapping the first electrode (AND) and the second opening portion (OP12, OP23, OP13) overlapping the power connection electrode (903);
a bank layer (SPR) on the intermediate layer (123), the bank layer (SPR) defining a third opening portion (OP4, OP5) overlapping the first opening portion (OP1, OP2, OP3) and a fourth opening portion (OP6, OP7) overlapping the second opening portion (OP12, OP23, OP13);
a light emitting stack layer (IL) on the first electrode (AND) and the bank layer (SPR); and
a second electrode (CAT) on the light emitting stack layer (IL) and electrically connected to the power connection electrode (903) through the second opening portion (OP12, OP23, OP13) and the fourth opening portion (OP6, OP7),
wherein the bank layer (SPR) has an undercut structure in the sub-pixel area (SP1, SP2, SP3), and the bank layer (SPR) has a non-undercut structure in the power connection area (CCA).

2. The display device (10) of claim 1, wherein in the sub-pixel area (SP1, SP2, SP3), the bank layer (SPR) comprises a first bank (BK1) and a second bank (BK2) on the first bank (BK1),
the third opening portion (OP4, OP5) of the bank layer (SPR) comprises a first opening (OP4) defined by the first bank (BK1) and a second opening (OP5) defined by the second bank (BK2), and
the first opening (OP4) of the third opening portion (OP4, OP5), the second opening (OP5) of the third opening portion (OP4, OP5), the first opening portion (OP1, OP2, OP3) of the intermediate layer (123), and the first electrode (AND) overlap.

3. The display device (10) of claim 2, wherein a width (W1) of the first opening (OP4) of the third opening portion (OP4, OP5) is greater than a width (W2) of the second opening (OP5) of the third opening portion (OP4, OP5).

4. The display device (10) of claim 2 or claim 3, wherein an etching rate of the first bank (BK1) is greater than an etching rate of the second bank (BK2).

5. The display device (10) of any one of claims 2 to 4, wherein in the sub-pixel area (SP1, SP2, SP3), an edge (E2) of the second bank (BK2) extends beyond an edge (E1) of the first bank (BK1) and towards the first opening portion (OP1, OP2, OP3) of the intermediate layer (123).

6. The display device (10) of any one of claims 1 to 5, wherein the bank layer (SPR) contains silicon oxide.

7. The display device (10) of any one of claims 1 to 6, wherein the intermediate layer (123) comprises:
a capping layer (CPL) on the first electrode (AND) and the power connection electrode
(903); and
a planarization layer (PNS) on the capping layer (CPL),
wherein the first opening portion (OP1, OP2, OP3) of the intermediate layer (123) comprises a first opening (OP1) and a second opening (OP2), the first opening (OP1) defined by the capping layer (CPL) and the second opening (OP2) defined by the planarization layer (PNS),
wherein the second opening portion (OP12, OP23, OP13) of the intermediate layer (123) comprises a third opening (OP12) and a fourth opening (OP23), the third opening (OP12) defined by the capping layer (CPL) and the fourth opening (OP23) defined by the planarization layer (PNS),
wherein the first opening (OP1) of the first opening portion (OP1, OP2, OP3), the second opening (OP2) of the first opening portion (OP1, OP2, OP3), and the first electrode (AND) overlap, and
the third opening (OP12) of the second opening portion (OP12, OP23, OP13), the fourth
opening (OP23) of the second opening
portion (OP12, OP23, OP13), and the power connection electrode (903) overlap, optionally wherein the intermediate layer (123) further comprises a protective layer (PTL) on the planarization layer (PNS),
the first opening portion (OP1, OP2, OP3) of the intermediate layer (123) further comprises a fifth opening (OP3) defined by the protective layer (PTL),
the second opening portion (OP12, OP23, OP13) of the intermediate layer (123) further comprises a sixth opening (OP13) defined by the protective layer (PTL),
the first opening (OP1) of the first opening portion (OP1, OP2, OP3), the second opening (OP2) of the first opening portion (OP1, OP2, OP3), the fifth opening (OP5) of the first opening portion (OP1, OP2, OP3), and the first electrode (AND) overlap, and
the third opening (OP12) of the second opening portion (OP12, OP23, OP13), the fourth opening (OP23) of the second opening portion (OP12, OP23, OP13), the sixth opening (OP13) of the second opening portion (OP12, OP23, OP13), and the power connection electrode (903) overlap.

8. The display device (10) of any one of claims 1 to 7, wherein in the power connection area (CCA), the bank layer (SPR) comprises a first bank (BK1) and a second bank (BK2) on the first bank (BK1),
the fourth opening portion (OP6, OP7) of the bank layer (SPR) comprises a first opening (OP6) and a second opening (OP7), the first opening (OP6) defined by the first bank (BK1) and the second opening (OP7) defined by the second bank (BK2), and
in the power connection area (CCA), an edge (E3) of the first bank (BK1) extends beyond an edge (E4) of the second bank (BK2) and towards the second opening portion (OP12, OP23, OP13) of the intermediate layer (123), optionally wherein a width (W3) of the first opening (OP6) of the fourth opening portion (OP6, OP7) is smaller than a width (W4) of the second opening (OP7) of the fourth opening portion (OP6, OP7).

9. The display device (10) of any one of claims 1 to 7, wherein in the power connection area (CCA), the bank layer (SPR) comprises a second bank (BK2),
the fourth opening portion (OP7) of the bank layer (SPR) comprises an opening (OP7) defined by the second bank (BK2), and
in the power connection area (CCA), an edge (E9) of the intermediate layer (123) extends beyond an edge (E10) of the second bank (BK2) and towards the second opening portion (OP12, OP23, OP13) of the intermediate layer (123), optionally wherein a width (W10) of the opening (OP7) of the fourth opening portion (OP7) is larger than a width (W9) of the second opening portion (OP12, OP23, OP13) of the intermediate layer (123).

10. The display device (10) of any one of claims 1 to 9, wherein in a dam area (DMA) of the non-display area (NDA) of the substrate (SSUB), the intermediate layer (123) further comprises a fifth opening portion (OP21, OP16, OP17),
the bank layer (SPR) further comprises a sixth opening portion (OP8, OP9) overlapping the fifth opening portion (OP21, OP16, OP17), and
in the dam area (DMA), the bank layer (SPR) has a non-undercut structure.

11. The display device (10) of claim 10, wherein:
(i) in the dam area (DMA), the bank layer comprises a first bank (BK1) and a second bank (BK2) on the first bank (BK1),
the sixth opening portion (OP8, OP9) of the bank layer (SPR) comprises a first opening (OP8) and a second opening (OP9), the first opening (OP8) defined by the first bank (BK1) and the second opening (OP9) defined by the second bank (BK2), and
in the dam area (DMA), an edge (E5) of the first bank (BK1) extends beyond an edge (E6) of the second bank (BK2) and towards the fifth opening portion (OP21, OP16, OP17) of the intermediate layer (123); or
(ii) in the dam area (DMA), the bank layer (SPR) comprises a second bank (BK2),
the sixth opening portion (OP9) of the bank layer (SPR) comprises an opening (OP9) defined by the second bank (BK2), and
in the dam area (DMA), an edge (E11) of the intermediate layer (123) extends beyond an edge (E12) of the second bank (BK2) and towards the fifth opening portion (OP21, OP16, OP17) of the intermediate layer (123).

12. The display device (10) of any one of claims 1 to 11, wherein in a pad area (PAD1) of the non-display area (NDA) of the substrate (SSUB), the intermediate layer (123) further comprises a seventh opening portion (OP22, OP18, OP20),
the bank layer (SPR) further comprises an eighth opening portion (OP10, OP11) overlapping the seventh opening portion (OP22, OP18, OP20), and
in the pad area (PAD1), the bank layer (SPR) has a non-undercut structure.

13. The display device (10) of claim 12, wherein:
(i) in the pad area (PAD1), the bank layer (SPR) comprises a first bank (BK1) and a second bank (BK2) on the first bank (BK1),
the eighth opening portion (OP10, OP11) of the bank layer (SPR) comprises a first opening (OP10) and a second opening (OP11), the first opening (OP10) defined by the first bank (BK1) and the second opening (OP11) defined by the second bank (BK2), and
in the pad area (PAD1), an edge (E7) of the first bank (BK1) extends beyond an edge (E8) of the second bank (BK2) and towards the seventh opening portion (OP22, OP18, OP20) of the intermediate layer (123); or
(ii) in the pad area (PAD1), the bank layer (SPR) comprises a second bank (BK2),
the eighth opening portion (OP11) of the bank layer (SPR) comprises an opening (OP11) defined by the second bank (BK2), and
in the pad area (PAD1), an edge (E13) of the intermediate layer (123) extends beyond an edge (E14) of the second bank (BK2) toward the seventh opening portion (OP22, OP18, OP20) of the intermediate layer (123).

14. An electronic device (50) comprising:
a display device (10) having a resolution of 4,000 pixels per inch (PPI) or more;
an optical member (1060) outside the display device (10), the optical member (1060) configured to adjust a path of light emitted from the display device (10); and
wherein the display device (10) comprises
a substrate (SSUB) comprising a display area (DAA) and a non-display area (NDA),
a first electrode (AND) located in a sub-pixel area (SP1, SP2, SP3) of the display area (DAA),
a power connection electrode (903) in a power connection area (CCA) of the non-display area (NDA),
an intermediate layer (123) on the first electrode (AND) and the power connection electrode (903), the intermediate layer (123) defining a first opening portion (OP1, OP2, OP3) and a second opening portion (OP12, OP23, OP13), the first opening portion (OP1, OP2, OP3) overlapping the first electrode (AND) and the second opening portion (OP12, OP23, OP13) overlapping the power connection electrode (903),
a bank layer (SPR) on the intermediate layer (123), the bank layer (SPR) defining a third opening portion (OP4, OP5) and a fourth opening portion (OP6, OP7), the third opening portion (OP4, OP5) overlapping the first opening portion (OP1, OP2, OP3) and the fourth opening portion (OP6, OP7) overlapping the second opening portion (OP12, OP23, OP13),
a light emitting stack layer (IL) on the first electrode (AND) and the bank layer (SPR), and
a second electrode (CAT) on the light emitting stack layer (IL) and connected to the power connection electrode (903) through the second opening portion (OP12, OP23, OP13) and the fourth opening portion (OP6, OP7), and
wherein the bank layer (SPR) has an undercut structure in the sub-pixel area (SP1, SP2, SP3), and the bank layer (SPR) has a non-undercut structure in the power connection area (CCA).

15. The electronic device (50) of claim 14, wherein the display device (10) comprises an active region and a non-active region outside the active region,
the active region configured to implement an image,
the non-active region configured to not implement the image, and
a maximum width of the active region is 1.5 inches or less.
